# EUROPEAN PATENT APPLICATION

(11) **EP 4 404 711 A1**
(43) Date of publication of application: **24.07.2024**
(21) Application number: 23218813.6
(22) Date of filing: 20.12.2023
(51) Int. Cl.: H10B 12/00

(54) **SEMICONDUCTOR DEVICE**

(30) Priority: 18.01.2023 KR 20230007620
(71) Applicant: Samsung Electronics Co., Ltd., Suwon-si, Gyeonggi-do 16677 (KR)
(72) Inventor: RIM, Taiuk, 16677 Suwon-si (KR); LEE, Jinseong, 16677 Suwon-si (KR); CHAE, Kyosuk, 16677 Suwon-si (KR)
(74) Representative: Marks & Clerk LLP

(57) **Abstract**

A semiconductor device may include a substrate including a cell region and a peripheral circuit region, a first gate structure in the cell region of the substrate, the first gate structure extending in a first direction parallel to an upper surface of the substrate, bit line structures on the cell region of the substrate, the bit line structures extending in a second direction perpendicular to the first direction and parallel to the upper surface of the substrate, a second gate structure on the peripheral circuit region of the substrate, contact plug structures between the bit line structures, the contact plug structures contacting the substrate, first conductive structures on peripheral circuit region of the substrate, the first conductive structures being electrically connected to the peripheral circuit region of the substrate, a first upper insulation structure between the first conductive structures, the first upper insulation structure including a first upper insulation pattern and a hydrogen diffusing insulation pattern surrounding a bottom and sidewalls of the first upper insulation pattern, and a second upper insulation pattern between upper portions of the contact plug structures.

## Description

### TECHNICAL FIELD

Various example embodiments relate to a DRAM (Dynamic random-access memory) semiconductor devices.

### BACKGROUND

In a DRAM device, memory cells may be formed in a cell region and transistors and wirings constituting a peripheral circuit may be formed in a peripheral circuit region. The DRAM device may have excellent characteristics by reducing trap sites on the surface of a substrate in which the memory cells and peripheral circuits are formed.

### SUMMARY

Various example embodiments provide a semiconductor device having improved electrical characteristics.

According to some example embodiments, there is provided a semiconductor device. The semiconductor device may include a substrate including a cell region and a peripheral circuit region, a first gate structure in the cell region of the substrate, the first gate structure extending in a first direction parallel to an upper surface of the substrate, bit line structures on the cell region of the substrate, the bit line structures extending in a second direction perpendicular to the first direction and parallel to the upper surface of the substrate, a second gate structure on the peripheral circuit region of the substrate, contact plug structures between the bit line structures, the contact plug structures contacting the substrate, first conductive structures on peripheral circuit region of the substrate, the first conductive structures being electrically connected to the peripheral circuit region of the substrate, a first upper insulation structure between the first conductive structures, the first upper insulation structure including a first upper insulation pattern and a hydrogen diffusing insulation pattern surrounding a bottom and sidewalls of the first upper insulation pattern, and a second upper insulation pattern between upper portions of the contact plug structures.

According to some example embodiments, there is provided a semiconductor device. The semiconductor device may include a substrate including a cell region and a peripheral circuit region, a first gate structure in the cell region of the substrate, the first gate structure extending in a first direction parallel to an upper surface of the substrate, bit line structures on the cell region of the substrate, the bit line structures extending in a second direction perpendicular to the first direction and parallel to the upper surface of the substrate, a second gate structure on the peripheral circuit region of the substrate, an insulating interlayer covering sidewalls of the second gate structure on the peripheral circuit region of the substrate, a first capping layer covering the insulating interlayer on the peripheral circuit region of the substrate, contact plug structures between the bit line structures, the contact plug structures contacting the substrate, first conductive structures on the first capping layer, a portion of the first conductive structures passing through the first capping layer and the insulating interlayer and contacting the peripheral circuit region of the substrate, a first upper insulation structure between the first conductive structures, the first upper insulation structure including a first upper insulation pattern and a hydrogen diffusing insulation pattern surrounding a bottom and sidewalls of the first upper insulation pattern, and a second upper insulation pattern between upper portions of the contact plug structures. The hydrogen diffusing insulation pattern includes a material having a hydrogen diffusivity higher than a hydrogen diffusivity of silicon nitride. At least a portion of the hydrogen diffusing insulation pattern directly contacts the insulating interlayer.

According to some example embodiments, there is provided a semiconductor device. The semiconductor device may include bit line structures on a cell region of a substrate, the bit line structures extending in one direction parallel to an upper surface of the substrate, a gate structure on a peripheral circuit region of the substrate, contact plug structures between the bit line structures, the contact plug structures contacting the substrate, first conductive structures on the peripheral circuit region of the substrate, a first upper insulation structure between the first conductive structures, and a second upper insulation pattern between upper portions of the contact plug structures, the second upper insulation pattern having a stacked structure different from a stacked structure of the first upper insulation structure. The first upper insulation structure includes a material having a hydrogen diffusivity higher than a hydrogen diffusivity of silicon nitride.

In various example embodiments, the semiconductor device may include a hydrogen diffusing insulation pattern between the first conductive structures. Thus, the hydrogen may be easily diffused onto the surface of the substrate. Trap sites on the surface of the substrate may be removed or reduced by the diffused hydrogen, and thus the characteristics of transistors formed on the substrate may be improved.

At least some of the above and other features of the invention are set out in the claims.

### BRIEF DESCRIPTION OF THE DRAWINGS

Various example embodiments will be more clearly understood from the following detailed description taken in conjunction with the accompanying drawings. FIGS. 1 to 27 represent various non-limiting, example embodiments as described herein.
FIGS. 1 to 22 are plan views and cross-sectional views illustrating a method of manufacturing a semiconductor device in accordance with various example embodiments;
FIG. 23 is a cross-sectional view illustrating a semiconductor device according to various example embodiments; and
FIGS. 24 to 27 are cross-sectional views illustrating a method of manufacturing a semiconductor device according to various example embodiments.

### DETAILED DESCRIPTION

Hereinafter, various example embodiments will be described in detail with reference to the accompanying drawings.

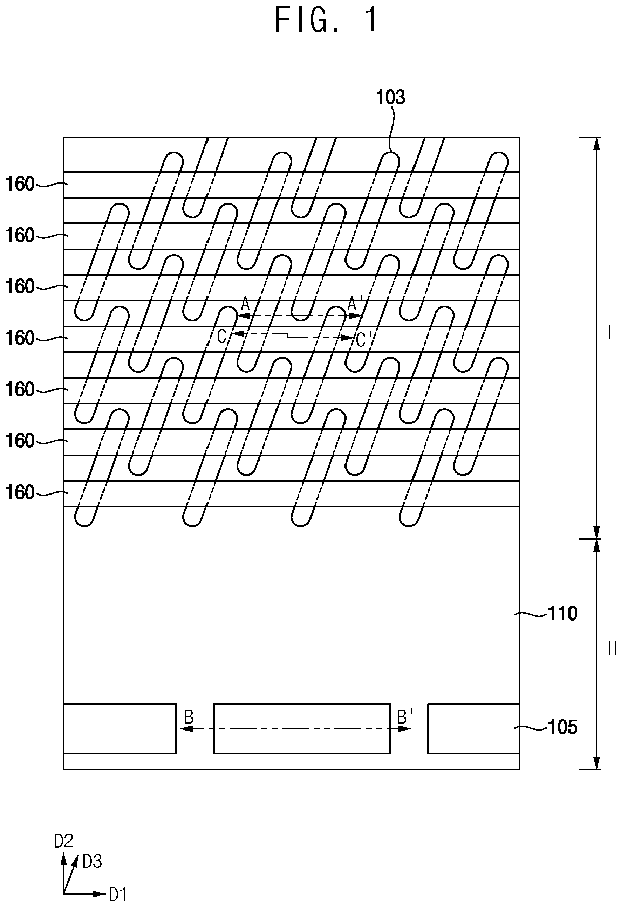

FIGS. 1 to 22 are plan views and cross-sectional views illustrating a method of manufacturing a semiconductor device in accordance with various example embodiments.

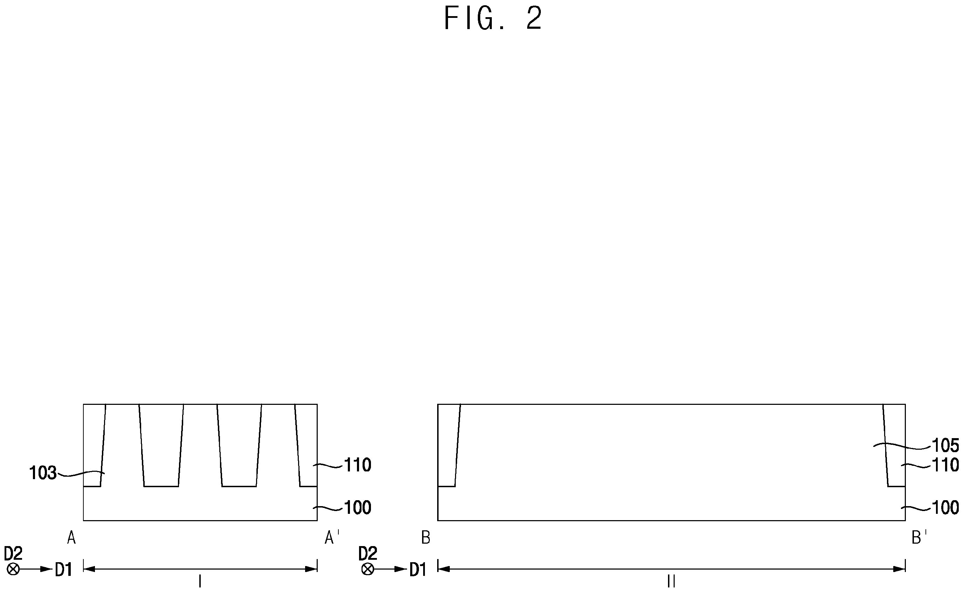

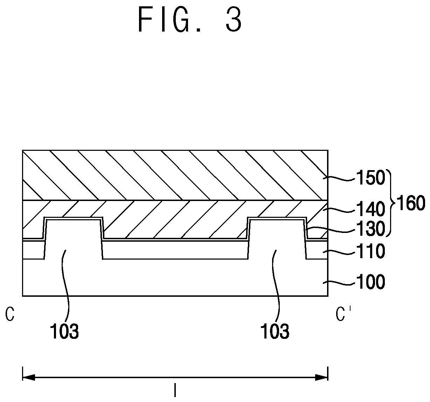

Particularly, FIGS. 1, 4, 9 and 20 are plan views, and FIGS. 2, 5 to 8, 10 to 19, 21 and 22 are cross-sectional views taken along line A-A' and line B-B' of the plan view. FIG. 3 is a cross-sectional view taken along the line C-C' of the plan view.

Hereinafter, two directions parallel to an upper surface of a substrate and perpendicular to each other are defined as first and second directions D 1 and D2, respectively. A direction parallel to the upper surface of the substrate and having an acute angle with respect to each of the first and second directions D 1 and D2 is defined as a third direction D3.

Referring to FIGS. 1 to 3, first and second active patterns 103 and 105 may be formed on a substrate 100 including first and second regions I and II, respectively. A device isolation pattern 110 may be formed between the first and second active patterns 103 and 105.

The first region I of the substrate 100 may be a cell region where memory cells are formed, and the second region II of the substrate 100 may be a peripheral circuit region where peripheral circuit patterns are formed. The second region II may surround the first region I.

An upper portion of the substrate 100 may be etched to form first trenches, and thus the first and second active patterns 103 and 105 between the first trenches may be formed. Each of the first active patterns 103 may extend in the third direction D3. A plurality of first active patterns 103 may be spaced apart from each other in each of the first and second directions D1 and D2. The second active patterns 105 may be formed in areas for forming the peripheral circuits. However, in order to avoid the complexity of the drawing, only one isolated second active pattern 105 may be illustrated in the cross-sectional views. The device isolation pattern 110 may be formed in the first trench.

Impurity regions may be formed on the first region I of the substrate 100 by an ion implantation process, and then the first active pattern 103 and the device isolation pattern 110 may be partially etched to form a first recess extending in the first direction D1.

Thereafter, a first gate structure 160 may be formed in the first recess. The first gate structure 160 may include a first gate insulation pattern 130 on a bottom and sidewalls of the first recess, a first gate electrode 140 on the first gate insulation pattern 130 to fill a lower portion of the first recess, and a first gate mask 150 on the first gate electrode 140 to fill an upper portion of the first recess. The first gate structure 160 may extend in the first direction D1 on the first region I of the substrate 100. A plurality of the first gate structure 160 may be spaced apart from each other in the second direction D2.

The first gate insulation pattern 130 may include an oxide, e.g., silicon oxide, and the first gate electrode 140 may include a metal, a metal nitride, a metal silicide, polysilicon doped with impurities, or the like. The first gate mask 150 may include a nitride, e.g., silicon nitride. However, example embodiments are not limited thereto.

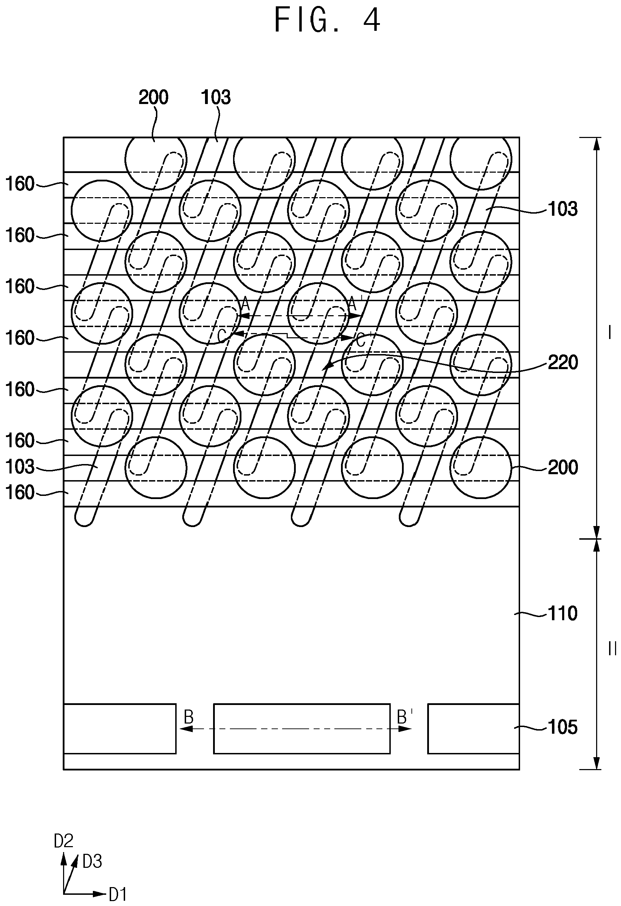

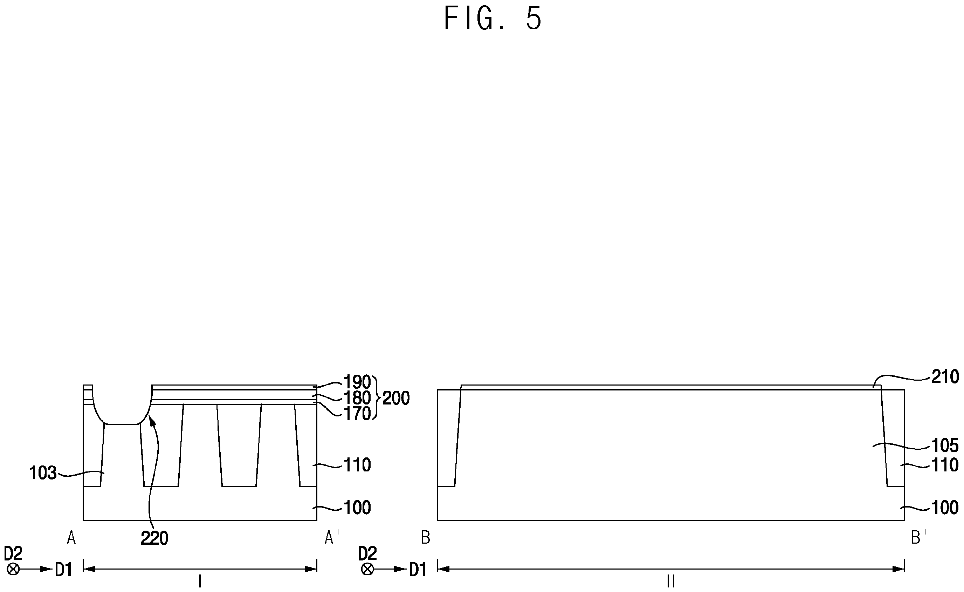

Referring to FIGS. 4 and 5, an insulation layer structure 200 may be formed on the first and second regions I and II of the substrate 100. The insulation layer structure 200 on the second region II of the substrate 100 except for a portion of the second region II adjacent to the first region I may be removed, and for example, a thermal oxidation process may be performed on the second active pattern 105 on the second region II of the substrate 100 to form a second gate insulation layer 210.

The insulation layer structure 200 may include first, second, and third insulation layers 170, 180 and 190 sequentially stacked. The first and third insulation layers 170 and 190 may include, oxide, e.g., silicon oxide, and the second insulation layer 180 may include a nitride, e.g., silicon nitride. However, example embodiments are not limited thereto.

Thereafter, the insulation layer structure 200 may be patterned. The first active pattern 103, the device isolation pattern 110, and the first gate mask of the first gate structure 160 may be partially etched using the patterned insulation layer structure 200 as an etching mask to form a first opening 220. In example embodiments, the insulation layer structures 200 remaining after the etching process may have a circular shape or an elliptical shape, in a plan view. A plurality of the insulation layer structures 200 may be spaced apart from each other in each of the first and second directions D1 and D2. Each of the insulation layer structures 200 may cover end portions in the third direction D3 of neighboring ones of the first active patterns 103 facing each other e.g. each of the insulation layer structures 200 may cover end portions in the third direction D3 of neighboring ones of the first active patterns 103 which are adjacent to each other in the first direction D1.

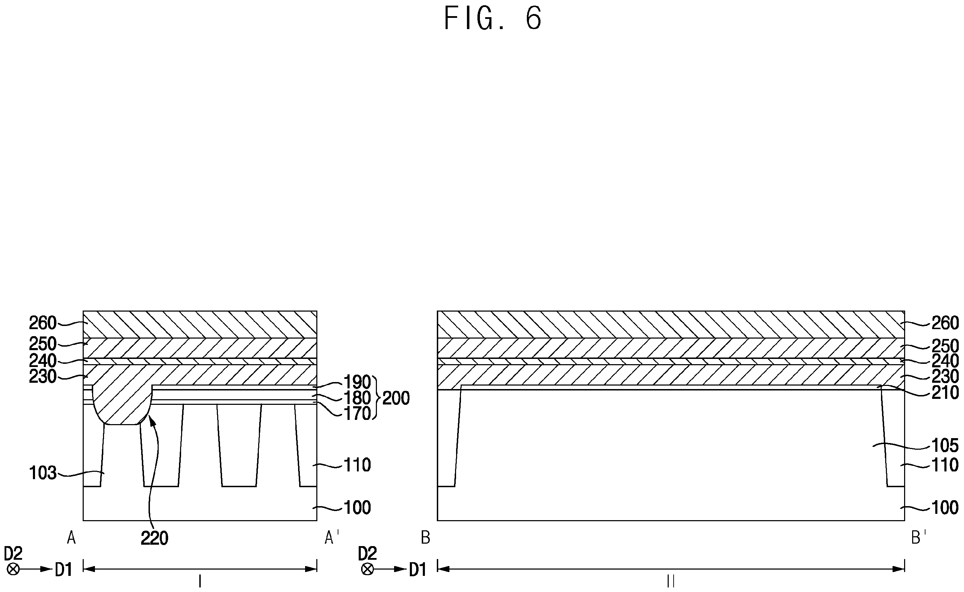

Referring to FIG. 6, a first conductive layer 230, a first barrier layer 240, a second conductive layer 250, and a first mask layer 260 may be sequentially formed on the insulation layer structure 200, the first active pattern 103, the device isolation pattern 110 and an upper surface of the first gate structure 160 exposed by the first opening 220 on the first region I of the substrate 100, and the second gate insulation layer 210 and the device isolation pattern 110 on the second region II of the substrate 100. In this case, the first conductive layer 230 may fill the first opening 220.

The first conductive layer 230 may include, e.g., polysilicon doped with impurities, and the first barrier layer 240 may include a metal silicon nitride, e.g., titanium silicon nitride (TiSiN). The second conductive layer 250 may include a metal, e.g., tungsten, and the first mask layer 260 may include a nitride, e.g., silicon nitride. However, example embodiments are not limited thereto.

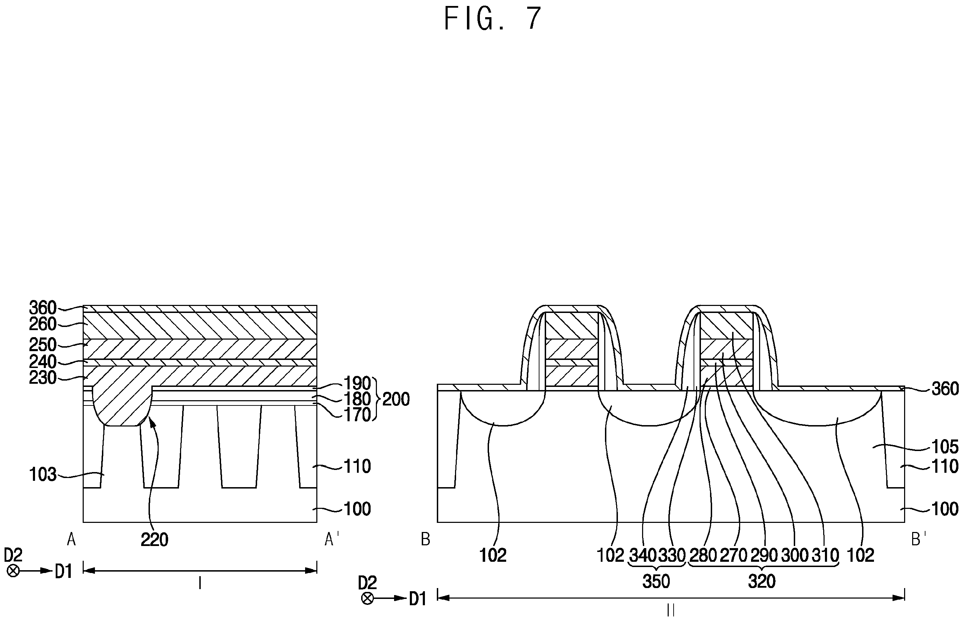

Referring to FIG. 7, a first etching mask pattern covering the first region I and exposing a portion of the second region II may be formed on the first mask layer 260. The first mask layer 260, the second conductive layer 250, the first barrier layer 240 and the first conductive layer 230 on the second region II may be sequentially etched using the first etching mask pattern to form a second gate structure 320 on the second region II of the substrate 100. The second gate structure 320 may include a second gate insulation pattern 270, a first conductive pattern 280, a first barrier pattern 290, and a second conductive pattern 300 and a second gate mask 310 sequentially stacked in a vertical direction perpendicular to the upper surface of the substrate 100. A structure including the first conductive pattern 280, the first barrier pattern 290 and the second conductive pattern 300 sequentially stacked may serve as a second gate electrode.

A gate spacer structure 350 may be formed on sidewalls of the second gate structure 320. The gate spacer structure 350 may include first and second gate spacers 330 and 340 sequentially stacked in a horizontal direction (e.g., a lateral direction). In example embodiments, the first gate spacer 330 may include, e.g., silicon nitride, and the second gate spacer 340 may include, e.g., silicon oxide. However, example embodiments are not limited thereto.

After forming the second gate structure 320, for example, an ion implantation process may be performed on an upper portion of the second active pattern 105 adjacent to the second gate structure 320 to form a first impurity region 102. The first impurity region 102 may serve as source/drain regions.

Thereafter, a first etch stop layer 360 may be formed on the first mask layer 260, the device isolation pattern 110, the second active pattern 105, the second gate structure, and the gate spacer structure 350 on the first and second regions I and II of the substrate 100. The first etch stop layer 360 may include, e.g., silicon nitride.

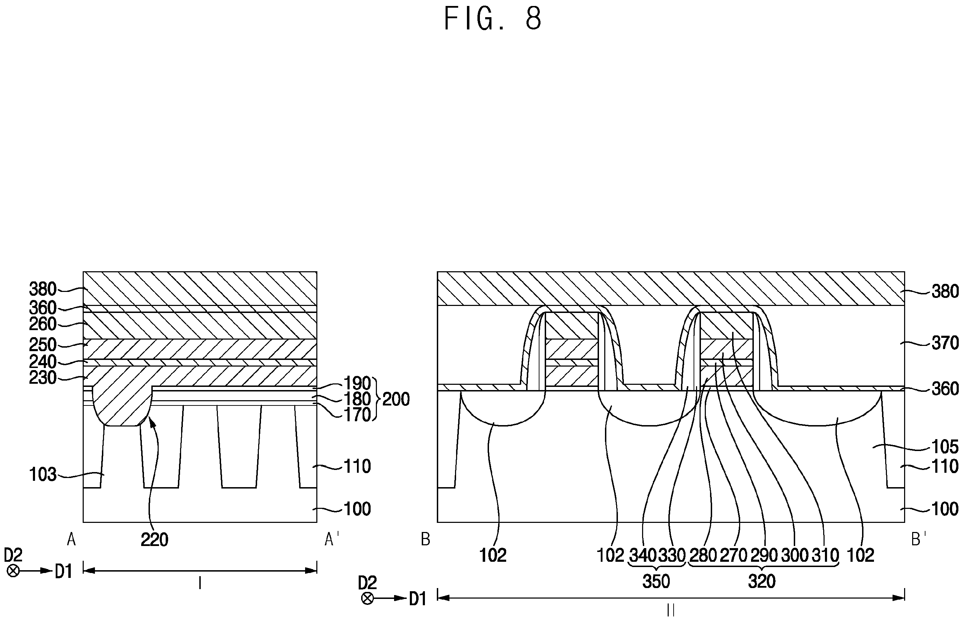

Referring to FIG. 8, a first insulating interlayer 370 may be formed on the first etch stop layer 360 to have a sufficient height. The first insulating interlayer 370 may be planarized until the first etch stop layer 360 on the upper surface of the second gate structure 320 and the first mask layer 260 are exposed. Accordingly, the first insulating interlayer 370 may fill a space between the gate spacer structures 350 on the sidewalls of the second gate structures 320.

Thereafter, a first capping layer 380 may be formed on the first insulating interlayer 370 and the first etch stop layer 360.

The first insulating interlayer 370 may include, e.g., silicon oxide, and the first capping layer 380 may include, e.g., silicon nitride. However, example embodiments are not limited thereto.

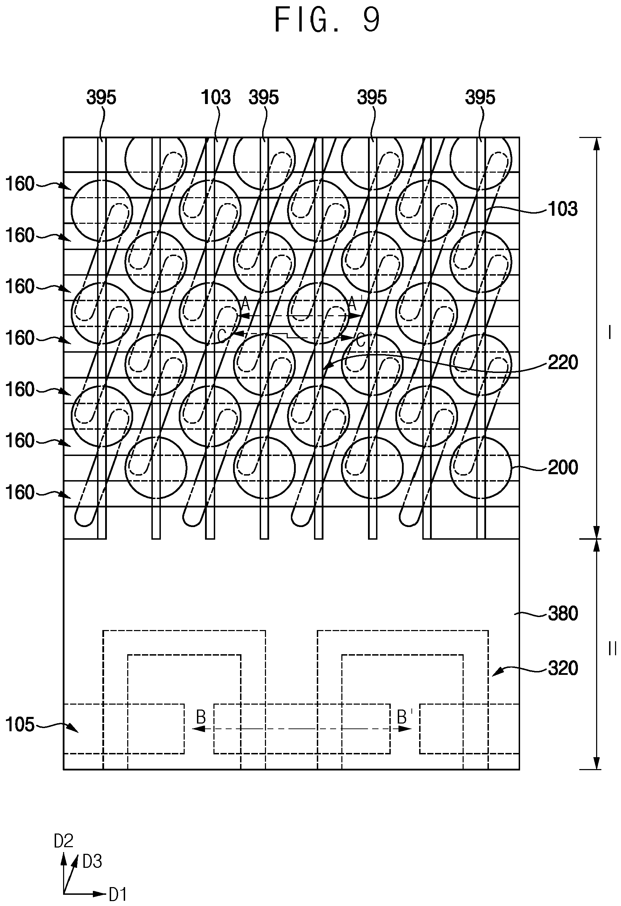

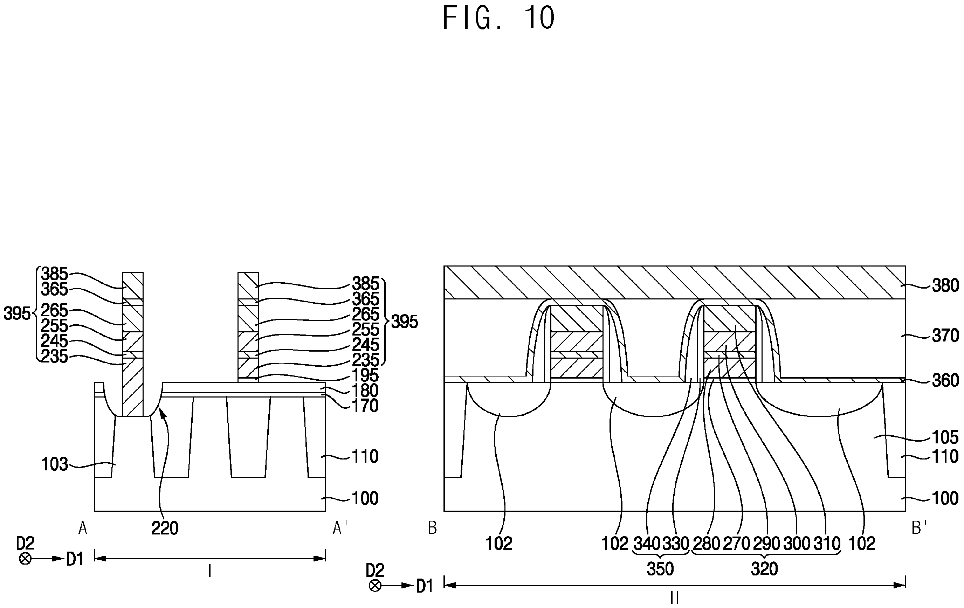

Referring to FIGS. 9 and 10, a portion of the first capping layer 380 on the first region I of the substrate 100 may be etched to form a first capping pattern 385. The first etch stop layer 360, the first mask layer 260, the second conductive layer 250, the first barrier layer 240 and the first conductive layer 230 may be sequentially etched using the first capping pattern 385 as an etch mask.

In example embodiments, the first capping pattern 385 may extend in the second direction D2 on the first region I of the substrate 100. A plurality of first capping patterns 385 may be spaced apart from each other in the first direction D1 on the first region I of the substrate 100. The first capping layer 380 may remain on the second region II of the substrate 100.

By the etching process, a third conductive pattern 235, a second barrier pattern 245, a fourth conductive pattern 255, a first mask 265, a first etch stop pattern 365 and a first capping pattern 385 may be sequentially stacked on the first opening 220 of the first region I of the substrate 100. A third insulation pattern 195, the third conductive pattern 235, the second barrier pattern 245, the fourth conductive pattern 255, the first mask 265, the first etch stop pattern 365 and the first capping pattern 385 may be sequentially stacked on the second insulation layer 180 of the insulation layer structure 200 at a position outside of the first opening 220.

Hereinafter, a structure including the third conductive pattern 235, the second barrier pattern 245, the fourth conductive pattern 255, the first mask 265, the first etch stop pattern 365, and the first capping pattern 385 sequentially stacked may be referred to as a bit line structure 395.

In example embodiments, the bit line structure 395 may extend in the second direction D2 on the first region I of the substrate 100. A plurality of the bit line structure 395 may be spaced apart from each other in the first direction D1 on the first region I of the substrate 100. The bit line structure 395 may extend in the second direction D2 while contacting the surface of the first active pattern 103 exposed by the first openings 220.

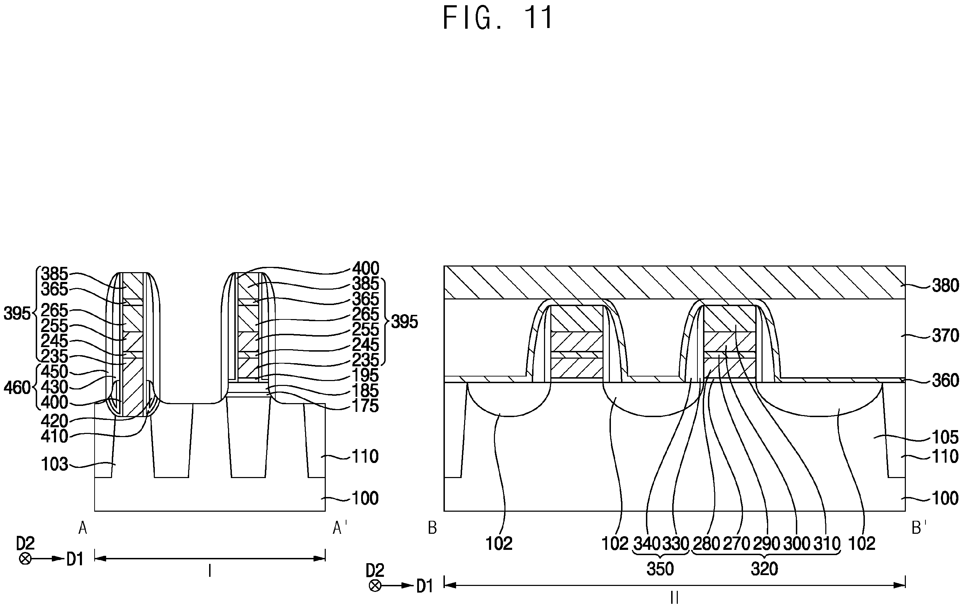

Referring to FIG. 11, a first spacer layer may be formed on the first active pattern 103, the device isolation pattern 110, and an upper surface of the first gate mask 150 exposed by the first opening 220, an inner wall of the first opening 220, the second insulation layer 180, and the first capping layer 380 to cover the bit line structure 395. A fourth insulation layer and fifth insulation layer may be sequentially formed on the first spacer layer.

The first spacer layer may also cover sidewalls of the third insulation pattern 195 below the bit line structure 395 on the second insulation layer 180, and thus the fourth and fifth insulation layers may fill a remaining portion of the first opening 220.

The first spacer layer may include a nitride, e.g., silicon nitride, the fourth insulation layer may include an oxide, e.g., silicon oxide, and the fifth insulation layer may include a nitride, e.g., silicon nitride. However, example embodiments are not limited thereto.

Thereafter, the fourth and fifth insulation layers may be etched by, e.g., a wet etching process. In example embodiments, the wet etching process may be performed using phosphoric acid (H2PO3), standard clean-1 (SC1) solution, and/or hydrofluoric acid (HF), or the like, as an etchant. However, example embodiments are not limited thereto. Other portions of the fourth and fifth insulation layers except for portions in the first opening 220 may be removed. Accordingly, most of a surface of the first spacer layer, that is other portions of the first spacer layer except for a portion of the face in the first opening 220 may be exposed, and portions of the fourth and fifth insulation layers remaining in the first opening 220 may form fourth and fifth insulation patterns 410 and 420, respectively.

Thereafter, a second spacer layer may be formed on an exposed surface of the first spacer layer, the fourth and fifth insulation patterns 410 and 420 in the first opening 220, and the first capping layer 380. The second spacer layer may be anisotropically etched to form a second spacer 430 covering a sidewall of the bit line structure 395 on the surface of the first spacer layer and the fourth and fifth insulation patterns 410 and 420. The second spacer layer may include an oxide, e.g., silicon oxide. However, example embodiments are not limited thereto.

Thereafter, a dry etching process using the first capping pattern 385 and the second spacer 430 as an etch mask may be performed to expose portions of an upper surface of the first active pattern 103. In addition, the upper surface of the device isolation pattern 110 and the upper surface of the first gate mask 150 may also be exposed.

By performing the dry etching process, a portion of the first spacer layer on an upper surface of the first capping pattern 385, an upper surface of the second insulation layer 180, and an upper surface of the first capping layer 380 may be removed to form a first spacer 400 covering the sidewall of the bit line structure 395. Also, in the dry etching process, the first and second insulation layers 170 and 180 may be also partially removed to form first and second insulation patterns 175 and 185 under the bit line structure 395, respectively. The first to third insulation patterns 175, 185 and 195 sequentially stacked under the bit line structure 395 may together form an insulation pattern structure.

A third spacer layer may be formed on the upper surface of the first capping pattern 385, the upper surface of the first capping layer 380, an outer wall of the second spacer 430, portions of the upper surfaces of the fourth and fifth insulation patterns 410 and 420, and exposed upper surfaces of the first active pattern 103, the device isolation pattern 110 and the first gate mask 150. The third spacer layer 450 may be anisotropically etched to form a third spacer 450 covering the sidewall of the bit line structure 395. A third spacer layer 450 may include a nitride, e.g., silicon nitride. However, example embodiments are not limited thereto.

The first to third spacers 400, 430, and 450 sequentially stacked in the horizontal direction on the sidewall of the bit line structure 395 on the first region I of the substrate 100 may be referred to as a preliminary spacer structure 460.

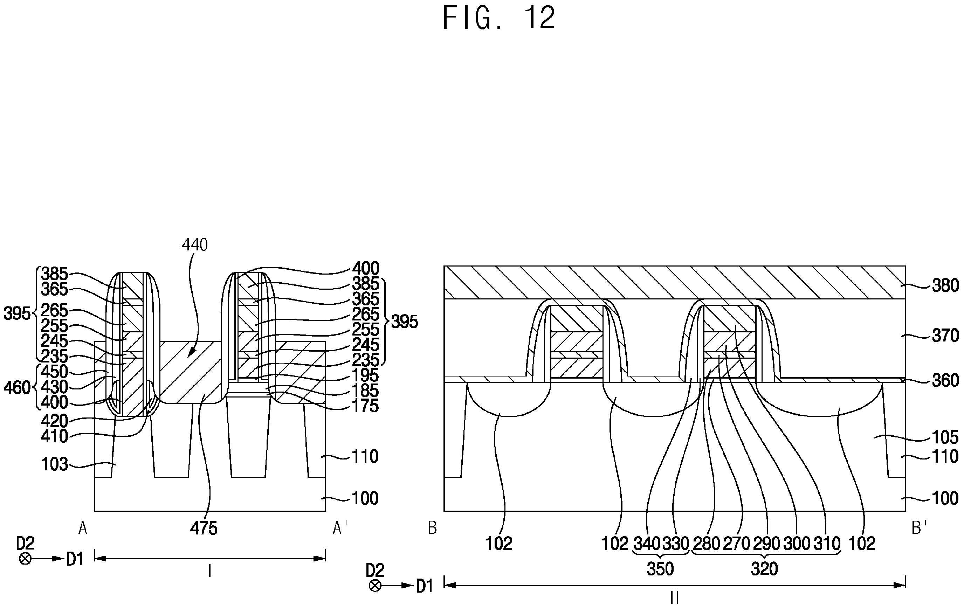

Referring to FIG. 12, a first sacrificial layer may be formed to fill a gap between the preliminary spacer structures 460. After forming a second etching mask pattern on the first sacrificial layer and the preliminary spacer structure 460, the first sacrificial layer may be etched using the second etching mask pattern to form a second opening.

In example embodiments, the second etching mask pattern may extend in the first direction D 1. A plurality of second etching masks may be spaced apart from each other in the second direction D2. In this case, the second opening may be formed to overlap the lower first gate structure 160 in the vertical direction. Thereafter, a fence insulation pattern may be formed to fill the second opening. The fence insulation pattern may include a nitride, e.g., silicon nitride. However, example embodiments are not limited thereto.

The first sacrificial layer may be removed to form a third opening 440 exposing the surface of the substrate 100. The third opening 440 may expose the surface of the substrate 100 corresponding to the space between the bit line structures 395 and the space between the first gate structures 160. The third opening 440 may expose a central portion of the first active pattern 103 in the third direction D3.

A lower contact plug layer may be formed to fill the third opening 440 on the first region I of the substrate 100. An upper portion of the lower contact plug layer may be etched to form a lower contact plug 475. In the etching process, the lower contact plug layer on the second region II may be removed, and the lower contact plug 475 may be formed only in a lower portion of the third opening 440. The lower contact plug 475 may include, e.g., polysilicon doped with impurities. The lower contact plug 475 may contact the surface of the substrate 100 corresponding to the space between the bit line structures 395 and the space between the first gate structures 160.

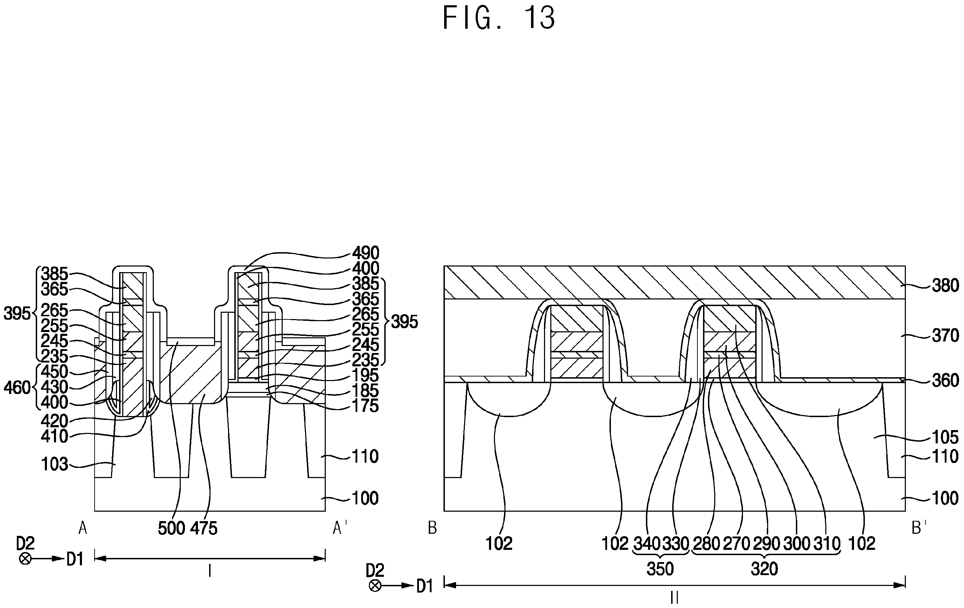

Referring to FIG. 13, upper portions of the second and third spacers 430 and 450 in exposed preliminary spacer structure 460 over the lower contact plug 475 may be removed.

Thereafter, a fourth spacer layer may be formed on the bit line structure 395, the preliminary spacer structure 460, the first capping pattern 385, the lower contact plug 475, and the first capping layer 380. The fourth spacer layer may be anisotropically etched to form a fourth spacer 490 covering an upper portion of the preliminary spacer structure 460 on both sidewalls in the first direction D1 of the bit line structure 395, and thus an upper surface of the lower contact plug 475 may be exposed.

Thereafter, a first metal silicide pattern 500 may be formed on the exposed upper surface of the lower contact plug 475. The first metal silicide pattern 500 may include, e.g., cobalt silicide, nickel silicide, titanium silicide, or the like. However, example embodiments are not limited thereto.

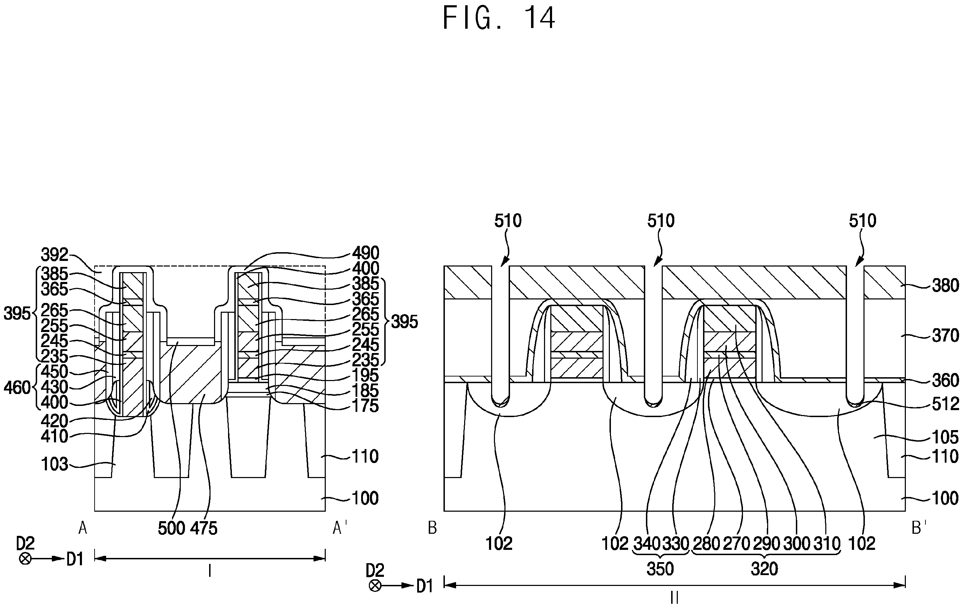

Referring to FIG. 14, a second sacrificial layer 392 may be formed on the first capping pattern 385, the first capping layer 380, the fourth spacer 490, the first metal silicide pattern 500, and the lower contact plug 475. The second sacrificial layer 392 may be planarized until the upper surfaces of the fourth spacer 490 on the first capping pattern 385 and the first capping layer 380 are exposed.

The second sacrificial layer 392 may include, e.g., a spin-on hard mask (SOH), diamond like carbon (DLC), amorphous carbon layer (ACL), or the like. However, example embodiments are not limited thereto.

Thereafter, a first contact hole 510 may be formed on the second region II of the substrate 100 through the first capping layer 380, the first insulating interlayer 370 and the first etch stop layer 360, and the first contact hole 510 may expose the second active pattern 105. The first contact hole 510 may expose the first impurity region 102 of the second active pattern 105. A second metal silicide pattern 512 may be formed on an upper surface of the second active pattern 105 exposed by a bottom of the first contact hole 510.

The second sacrificial layer 392 may be removed.

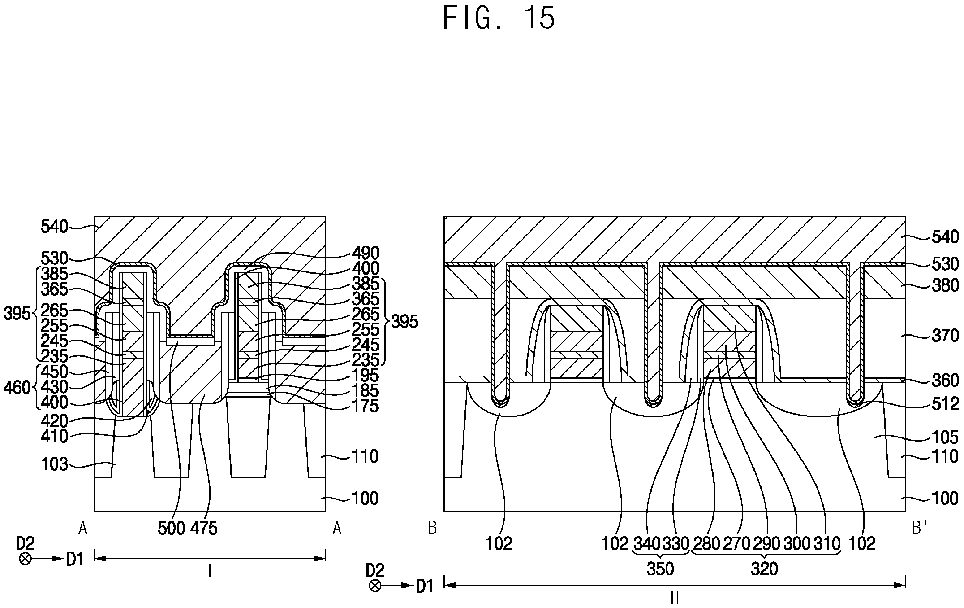

Referring to FIG. 15, a second barrier layer 530 may be formed on the fourth spacer 490, the first metal silicide pattern 500 and the lower contact plug 475 on the first region I of the substrate 100, and on the first capping layer 380, the surfaces of the first contact holes 510 and the second metal silicide pattern 512 on the second region II of the substrate 100. A first metal layer 540 may be formed on the second barrier layer 530 to fill the first contact hole 510 and the space between the bit line structures 395.

In example embodiments, the second barrier layer 530 may include, e.g., titanium, titanium nitride, tantalum, or tantalum nitride, and the first metal layer 540 may include, e.g., tungsten. However, example embodiments are not limited thereto.

Thereafter, a planarization process may be additionally performed on the upper portion of the first metal layer 540. The planarization process may include, e.g., a chemical mechanical polishing (CMP) process and/or an etch back process. However, example embodiments are not limited thereto.

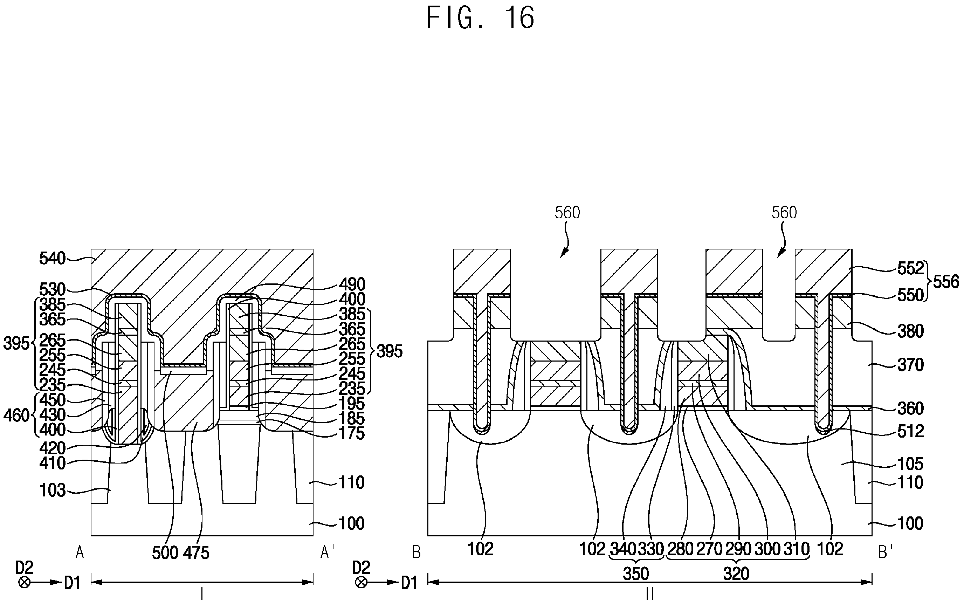

Referring to FIG. 16, a third etching mask pattern may be formed on the first metal layer 540. The first metal layer 540, the second barrier layer 530 and the first capping layer 380 on the second region II of the substrate 100 may be patterned using the third etching mask pattern to form first conductive structures conductive pattern and fourth openings 560. The third etching mask may entirely cover the first metal layer 540 on the first region I of the substrate 100.

At least portions of the first insulating interlayer 370 may be exposed by a bottom of the fourth opening 560, after the patterning process. In the patterning process, upper portions of the first etch stop layer 360 and the second gate mask 310 may be partially etched.

The first conductive structures 556 may include a third barrier pattern 550 and a first metal layer pattern 552. The first conductive structure 556 may include a first contact plug inside the first contact hole 510 and a first conductive line on the first capping layer 380. For example, the first contact plug may contact the first impurity region 102 on the second region II of the substrate 100. The first conductive structures 556 may be electrically connected to transistors of peripheral circuits on the second region II of the substrate 100.

Thereafter, the third etching mask pattern may be removed.

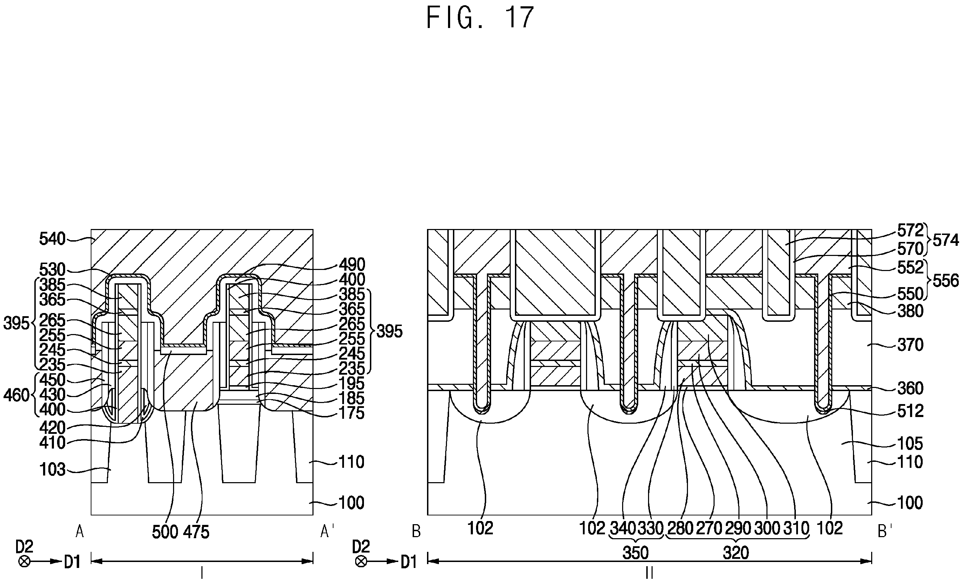

Referring to FIG. 17, a hydrogen diffusing insulation layer may be conformally formed on surfaces of the fourth opening 560, the first conductive structure 556 and the first metal layer 540. A sixth insulation layer may be formed on the hydrogen diffusing insulation layer to fill the fourth opening 560.

The hydrogen diffusing insulation layer may include a material through which the hydrogen easily diffuses in subsequent processes. The hydrogen diffusing insulation layer may include a material having a hydrogen diffusivity higher than a hydrogen diffusivity of a silicon nitride. The hydrogen diffusing insulation layer may include a silicon oxide, or silicon nitride mixed (or, doped) with other materials as impurities. However, example embodiments are not limited thereto.

In example embodiments, the hydrogen diffusing insulation layer may include, e.g., SiCN, SiO2, SiBN, or the like. However, since silicon nitride (SiN) is a material that hardly diffuses the hydrogen, the hydrogen diffusing insulation layer may not include silicon nitride.

The sixth insulation layer may include, e.g., silicon nitride.

Thereafter, the hydrogen diffusing insulation layer and the sixth insulation layer may be planarized until the first conductive structure 556 and the first metal layer 540 are exposed to form a hydrogen diffusing insulation pattern 570 and a first upper insulation pattern 572 filling the fourth opening 560. The hydrogen diffusing insulation pattern 570 and the first upper insulation pattern 572 may serve as a first upper insulation structure 574. The hydrogen diffusing insulation pattern 570 may be conformally formed on sidewalls and a bottom of the first upper insulation pattern 572. The hydrogen diffusing insulation pattern 570 may surround a bottom and sidewalls of the first upper insulation pattern 572.

A lower surface of the hydrogen diffusing insulation pattern 570 may directly contact at least upper portions of the first insulating interlayer 370. Therefore, the hydrogen supplied in subsequent processes may easily and downwardly diffuse through the hydrogen diffusing insulation pattern 570 and the first insulating interlayer 370 contacting the hydrogen diffusing insulation pattern 570, so that the hydrogen may be supplied onto the surface of the substrate 100.

If the hydrogen diffusing insulation pattern is not provided, the hydrogen supplied in the subsequent processes may be blocked by the first upper insulation pattern 572. Therefore, it may be difficult for the hydrogen to diffuse downwardly, and thus the hydrogen may not be supplied onto the surface of the substrate 100.

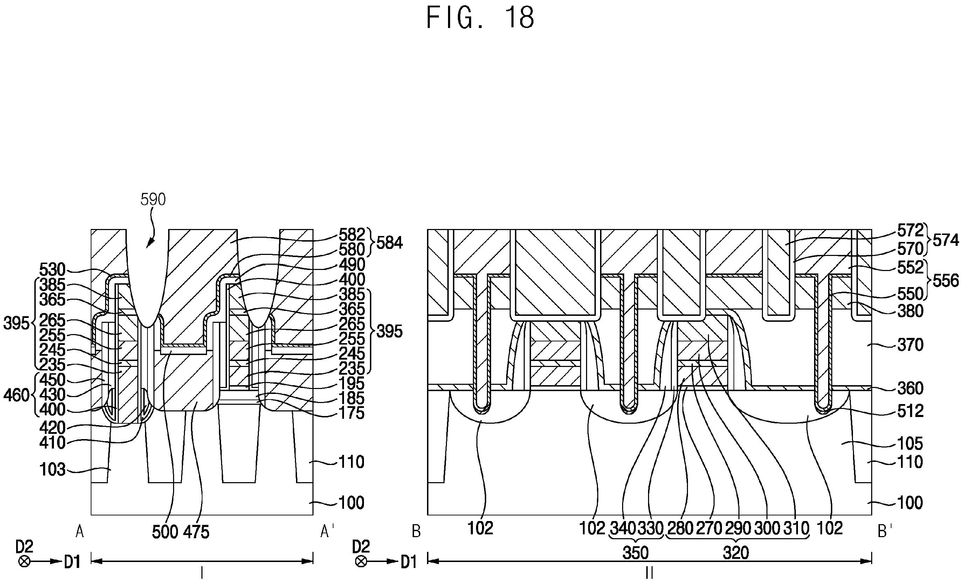

Referring to FIG. 18, a fourth etching mask pattern may be formed on the first metal layer 540, the hydrogen diffusing insulation pattern 570, the first upper insulation pattern 572, and the first conductive structure 556. The first metal layer 540 and the second barrier layer 530 on the first region I of the substrate 100 may be patterned using the fourth etching mask pattern to form upper contact plug structures 584 and fifth openings 590. The fourth etching mask pattern may entirely cover the insulation pattern of hydrogen diffusion 570, the first upper insulation pattern 572 and the first conductive structure 556 on the second region II of the substrate 100. The upper contact plug structure 584 may include a second metal pattern 582 and a fourth barrier pattern 580.

In the patterning process, not only the first metal layer 540 and the second barrier layer 530, but also the upper portion of the first capping pattern 385, the upper portion of the preliminary spacer structure 460, and the upper portion of the fourth spacer 490 may be etched together. Accordingly, an upper surface of the second spacer 430 may be exposed by a bottom of the fifth opening 590. A spacer structure in which the first to fourth spacers 400, 430, 450 and 490 are stacked may be formed on the sidewalls of the bit line structure 395.

In some example embodiments, the second spacer 430 may be removed to form an air spacer.

As the fifth opening 590 is formed, the first metal layer 540 and the second barrier layer 530 on the first region I of the substrate 100 may be transformed into the second metal pattern 582 and the fourth barrier pattern 580 covering a lower portion of the second metal pattern 582, respectively. The second metal pattern 582 and the fourth barrier pattern 580 may be referred to as an upper contact plug structure 584 together. In example embodiments, a plurality of upper contact plug structures 584 may be spaced apart from each other in the first and second directions D1 and D2, and the plurality of upper contact plug structures 584 may be arranged in a honeycomb shape, in a plan view. Each of the upper contact plug structures 584 may have a circular shape, an elliptical shape, a polygonal shape, or the like, in a plan view. However, example embodiments are not limited thereto.

The lower contact plug 475, the first metal silicide pattern 500, and the upper contact plug structure 584 that are sequentially stacked on the first region I of the substrate 100 may form a contact plug structure.

After that, the fourth etching mask pattern may be removed.

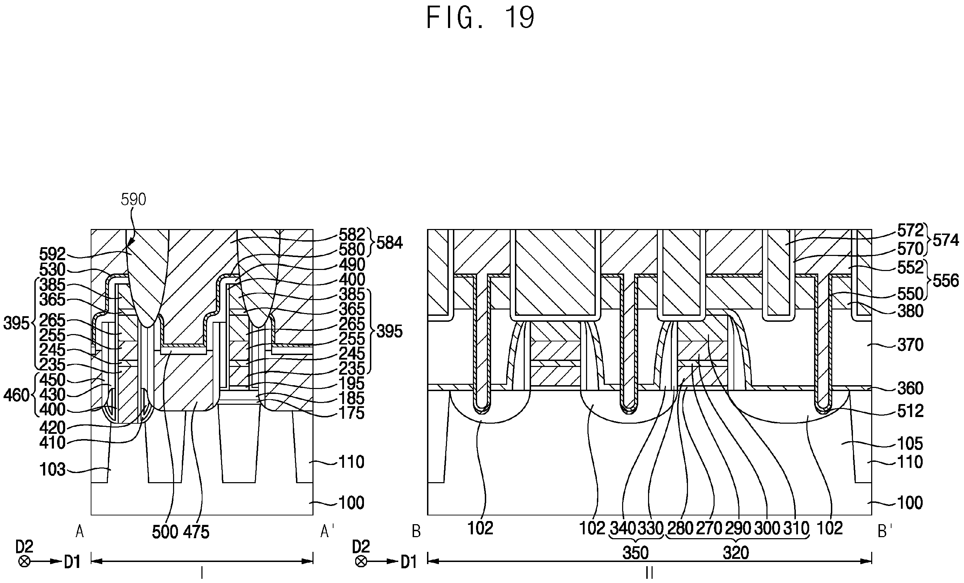

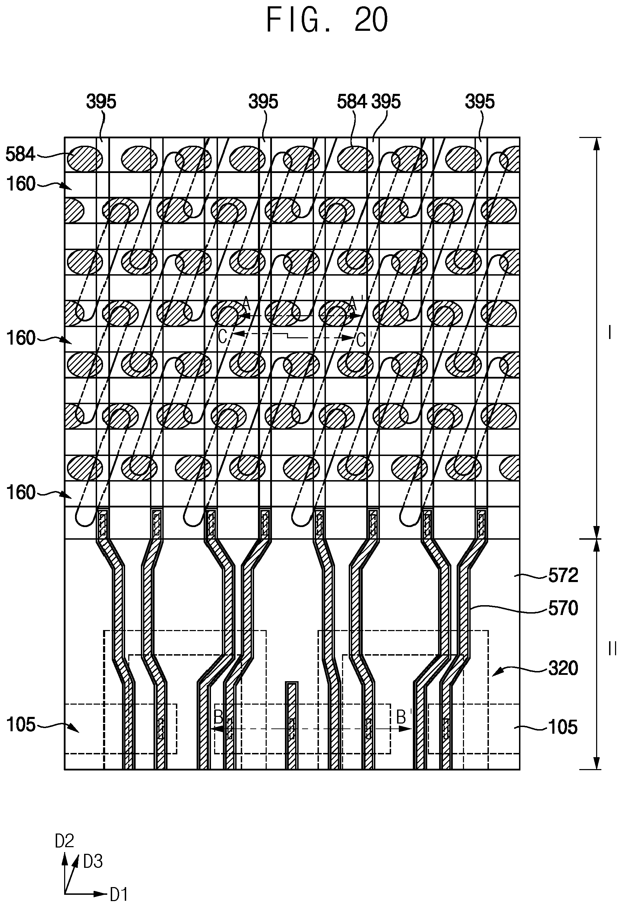

Referring to FIGS. 19 and 20, a seventh insulation layer may be formed on the upper contact plug structure 584, the hydrogen diffusing insulation pattern 570, the first upper insulation pattern 572, and the first conductive structure 556 to fill the fifth opening 590.

The seventh insulation layer may include a material that blocks diffusion of an impurity gas such as chlorine. In example embodiments, the seventh insulation layer may include, e.g., silicon nitride. In example embodiments, the seventh insulation layer may include a material substantially the same as a material of the first upper insulation pattern 572.

The material used as the hydrogen diffusing insulation pattern 570 may not effectively prevent diffusion of the impurity gas such as chlorine. Therefore, the material used as the hydrogen diffusing insulation pattern 570 may not be formed on the surface of the fifth opening 590. That is, materials such as SiCN, SiO2, or SiBN may not be formed in the fifth opening 590. If the material used as the hydrogen diffusing insulation pattern 570 may be formed in the fifth opening 590, the impurity gas such as chlorine may diffuse onto the surface of the substrate 100 in subsequent processes and may chemically react with the surface of the substrate 100. Thus, damages of the surface of the substrate 100 may occur.

Thereafter, the seventh insulation layer may be planarized until the first conductive structure 556 and the upper contact plug structure 584 are exposed to form a second upper insulation pattern 592 filling the fifth opening 590. That is, the second upper insulation pattern 592 on the first region I of the substrate 100 and the first upper insulation structure 574 on the second region II of the substrate 100 may have different structures.

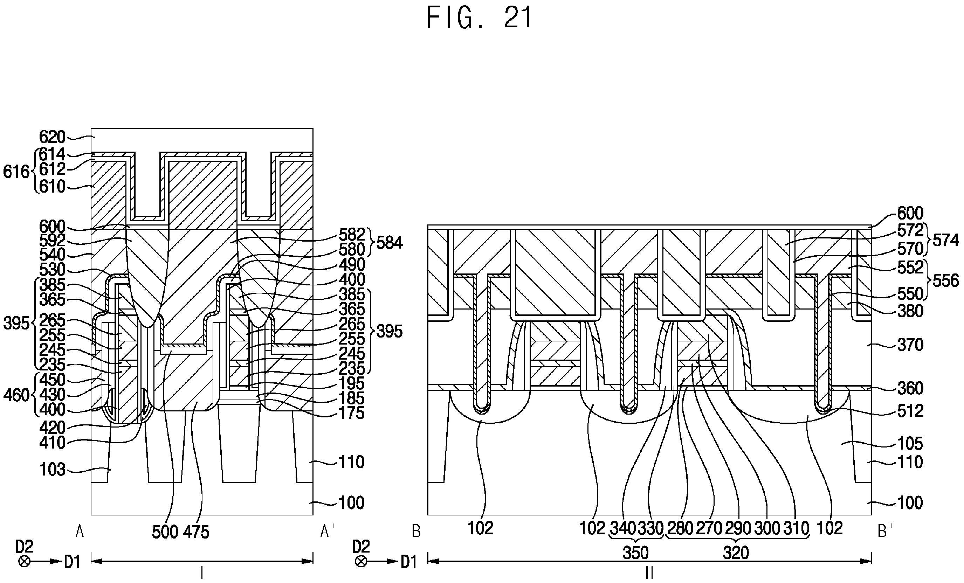

Referring to FIG. 21, a second etch stop layer 600 may be formed on the upper contact plug structure 584, the second upper insulation pattern 592, the hydrogen diffusing insulation pattern 570, the first upper insulation pattern 572 and the first conductive structure 556. A cell capacitor 616 may be formed through the second etch stop layer 600, and may contact the upper contact plug structure 584 on the first region I of the substrate 100. The cell capacitor 616 may include a lower electrode 610, a dielectric layer 612, and an upper electrode 614. A plate electrode 620 may be formed on the upper electrode 614 of the cell capacitor 616. The plate electrode 620 may include polysilicon and/or silicon germanium. However, example embodiments are not limited thereto.

A material of the second etch stop layer 600 may have an etch selectivity with respect to a silicon oxide, and may easily diffuse the hydrogen. The second etch stop layer 600 may have a hydrogen diffusivity higher than a hydrogen diffusivity of silicon nitride. The second etch stop layer 600 may include a silicon nitride material which may be mixed (or, doped) with other materials as impurities.

In example embodiments, the second etch stop layer 600 may include, e.g., SiCN or SiBN. However, example embodiments are not limited thereto. The second etch stop layer 600 may not include silicon nitride.

In the second region II of the substrate 100, the hydrogen diffusing insulation pattern 570 may connect the second etch stop layer 600 and the first insulating interlayer 370 to each other. Accordingly, the hydrogen may be diffused through a path of the second etch stop layer 600, the hydrogen diffusing insulation pattern 570 and the first insulating interlayer 370.

For forming the cell capacitor 616, a mold layer may be formed on the second etch stop layer 600, and a portion of the mold layer may be etched to form a sixth opening partially exposing the upper surface of the upper contact plug structure 584.

A lower electrode layer (not shown) may be formed on the mold layer to fill the sixth opening. An upper portion of the lower electrode layer may be planarized until the upper surface of the mold layer is exposed so as to separate nodes of the lower electrode layer. The remaining mold layer may be removed by, e.g., a wet etching process, a dry etching process, or an ashing process. However, example embodiments are not limited thereto. A lower electrode 610 having a pillar shape may be formed on the upper surface of the upper contact plug structure 584. Alternatively, a lower electrode 610 having a cylindrical shape may be formed on the surface of the sixth opening.

The dielectric layer 612 may be formed on the surface of the lower electrode 610 and the second etch stop layer 600, and the upper electrode 614 may be formed on the dielectric layer 612. Therefore, the cell capacitor including the lower electrode 610, the dielectric layer 612, and the upper electrode 614 may be formed on the first region I of the substrate 100.

The lower electrode 610 and upper electrode 614 may include metal. The lower electrode 610 and the upper electrode 614 may be formed by e.g., an atomic layer deposition process, a chemical vapor deposition process (CVD), or the like. However, example embodiments are not limited thereto. In non-limiting example embodiments, the lower electrode 610 and the upper electrode 614 may include, e.g., titanium nitride, polysilicon, tungsten, or the like. In this case, in the process for forming the lower electrode 610 and the upper electrode 614, a titanium source gas may use, e.g., TiCl4, and a nitride source gas may use, e.g., HN3.

The dielectric layer 612 may include a metal oxide having a dielectric constant higher than a dielectric constant of the silicon nitride. The dielectric layer 612 may include, e.g., aluminum oxide, hafnium oxide, or zirconium oxide. However, example embodiments are not limited thereto.

In example embodiments, in the process for forming the lower electrode 610 and the upper electrode 614 in the cell capacitor 616, a deposition source gas including chlorine may be used. The chlorine may diffuse below the cell capacitor 616. However, the second upper insulation pattern 592 on the first region I of the substrate 100 may include, e.g., the silicon nitride, and may not include the material used as the hydrogen diffusing insulation pattern 570. Therefore, the second upper insulation pattern 592 may prevent and/or reduce the downward diffusion of chlorine. If the chlorine diffuses downwardly to underlying layers, chemical damages of the substrate 100 may occur.

Since the cell capacitor 616 is not formed on the second region II of the substrate 100, chemical damage of the substrate 100 due to the diffusion of the chlorine may not be significant. Therefore, even if the hydrogen diffusing insulation pattern 570 is formed on the second region II of the substrate 100, defects due to the diffusion of chlorine may hardly occur.

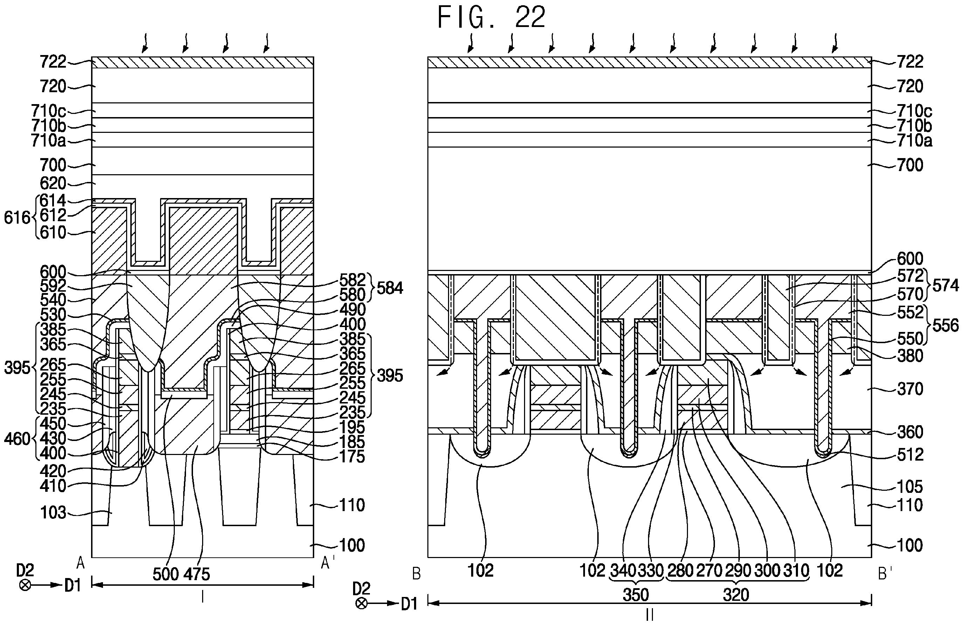

Referring to FIG. 22, a second insulating interlayer 700 may be formed to cover the plate electrode 620 and the second etch stop layer 600. An upper wiring may be formed in the second insulating interlayer 700. Low-k dielectric layers 710a, 710b and 710c and multi-layered metal wirings in the low-k dielectric layers 710a, 710b and 710c may be formed on the second insulating interlayer 700. The multi-layered metal wirings may include, e.g., copper, aluminum, tungsten, or the like. However, example embodiments are not limited thereto.

An hydrogen supplying oxide layer 720 may be formed on an uppermost low-k dielectric layer 710c. An upper capping layer 722 may be formed on the hydrogen supplying oxide layer 720. The hydrogen supplying oxide layer 720 may be, e.g., silicon oxide including hydrogen. The hydrogen supplying oxide layer 720 may be, e.g., a high-density plasma (HDP) oxide layer, a plasma enhanced CVD silane oxide layer, or the like. However, example embodiments are not limited thereto. The upper capping layer 722 may prevent the hydrogen from diffusing upwardly. The upper capping layer 722 may include, e.g., silicon nitride, silicon oxynitride, or the like. However, example embodiments are not limited thereto.

An alloy process may be performed to diffuse the hydrogen included in the hydrogen supplying oxide layer 720 onto the upper surface of the substrate 100.

The alloy process may include heat treatment performed at a temperature of about 300°C to about 500°C or more for tens to hundreds of minutes. In the heat treatment process, the hydrogen included in the hydrogen supplying oxide layer 720 may downwardly diffuse. Accordingly, the hydrogen may be transferred onto the surface of the substrate 100 through the multi-layered wirings and the wirings thereunder on the first region I. In addition, the hydrogen may be transferred onto the surface of the substrate 100 through the hydrogen diffusing insulation pattern 570 and the first insulating interlayer 370 on the second region II.

During the manufacturing processes of the semiconductor device, trap sites (e.g., dangling bonds) may be generated at an interface between the first gate insulation pattern 130 of the cell transistor and the substrate 100 and at an interface between the second gate insulation pattern 270 of the peripheral circuit transistor and the substrate 100. Leakage currents of the semiconductor device may be increased by the trap sites. In the case of a DRAM device, a refresh process, when data stored in memory cell is rewritten to the memory cell, may be performed during normal operation of the device. In order to improve the speed and durability of the DRAM device, it is desired to increase the refresh cycle and a data retention times. However, when trap sites are present at an interface of the substrate 100, leakage currents may generate in the cell transistors and the peripheral circuit transistors due to these trap sites. Thus, the refresh cycle and data retention times may be decreased. For removing the trap sites at the interface between the first gate insulation pattern 130 and the substrate 100, and at the interface between the second gate insulation pattern 270 and the substrate 100, the alloy process for diffusing the hydrogen onto the substrate 100 may be performed thereby diffusing the hydrogen into these trap sites.

When the hydrogen included in the hydrogen supplying oxide layer 720 is diffused to the surface of the substrate 100, the trap sites may be removed by combining hydrogen with the trap sites. Accordingly, in the DRAM device, the leakage currents due to the trap sites may be decreased, and data retention time may be increased.

As described above, in the second region II of the substrate 100, the hydrogen may be easily diffused through the path of the second etch stop layer 600, the hydrogen diffusing insulation pattern 570, and the first insulating interlayer 370. Therefore, the number of trap sites may be decreased, and the electrical characteristics of the semiconductor device may be improved.

The semiconductor device may be manufactured by the above processes.

The semiconductor device manufactured by the above processes may have the following structural characteristics.

The semiconductor device may be described with reference to FIGS. 19 to 22.

Referring to FIGS. 19 to 22 again, the semiconductor device may be formed on a substrate 100 including a first region I and a second region II.

First active patterns 103 may be formed on the first region I of the substrate 100, and second active patterns 105 may be formed on the second region II of the substrate 100. A device isolation pattern 110 may be formed between the first and second active patterns 103 and 105.

A first gate structure 160, a bit line structure 395, a spacer structure, a second upper insulation pattern 592, a contact plug structure and a cell capacitor 616 may be formed on the first region I of the substrate 100. A second gate structure 320, a first insulating interlayer 370, a first conductive structure 556, a hydrogen diffusing insulation pattern 570 and a first upper insulation pattern 572 may be formed on the second region II of the substrate 100. In addition, a second insulating interlayer 700, low-k dielectric layers 710a, 710b, and 710c, an upper wiring, a metal wiring, a hydrogen supplying oxide layer 720 and an upper capping layer 722 may be further formed on the first and second regions I and II of the substrate 100.

As shown in FIG. 3, the first gate structure 160 may be buried in the first region I of the substrate 100. That is, the first gate structure 160 may extend in the first direction D1 through upper portions of the active pattern 103 and the device isolation pattern 110. A plurality of first gate structures 160 may be spaced apart from each other in the second direction D2. The first gate structure 160 may include a first gate insulation pattern 130, a first gate electrode 140 and a first gate mask 150. Impurity regions may be formed at upper portions of the first active pattern 103 adjacent to the first gate structure 160. The first gate structure 160 and the impurity regions may serve as a cell transistor.

The first gate insulation pattern 130 may be formed on a surface of the first active pattern 103, and the first gate electrode 140 may be formed on the first gate insulation pattern 130 and the device isolation pattern 110. The first gate electrode 140 may extend in the first direction D1. The first gate mask 150 may cover an upper surface of the first gate electrode 140.

The first gate insulation pattern 130 may include an oxide, e.g., silicon oxide, and the first gate electrode 140 may include metal, e.g., tungsten (W), titanium (Ti), or tantalum (Ta), or a metal nitride, e.g., tungsten nitride, titanium nitride, or tantalum nitride, and the first gate mask 150 may include a nitride, e.g., silicon nitride. However, example embodiments are not limited thereto.

An insulation pattern structure may be formed on the first active pattern 103 and the device isolation pattern 110 on the first region I. The insulation pattern structure may include a first insulation pattern 175, a second insulation pattern 185 and a third insulation pattern 195 sequentially stacked.

The bit line structure 395 on the first region I may include a third conductive pattern 235, a second barrier pattern 245, a fourth conductive pattern 255, a first mask 265, a first etch stop pattern 365, and a first capping pattern 385 sequentially stacked. In example embodiments, the bit line structure 395 may be formed on the first active pattern 103 and the third insulation pattern 195, and may extend in the second direction D2. The plurality of bit line structures 395 may be spaced apart from each other in the first direction D1. The bottom of the bit line structure 395 may contact a portion of the surface of the first active pattern 103 and a portion of the third insulation pattern 195.

The third conductive pattern 235 may include, e.g., polysilicon doped with impurities. The second barrier pattern 245 may include a metal, e.g., titanium or tantalum, and/or a metal nitride, e.g., titanium nitride and tantalum nitride, and the fourth conductive pattern 255 may include a metal, e.g., tungsten. The first mask 265, the first etch stop pattern 365 and the first capping pattern 385 may include a nitride, e.g., silicon nitride. However, example embodiments are not limited thereto.

The second gate structure 320 may be formed on the second active pattern 105 on the second region II of the substrate 100.

The second gate structure 320 may include a second gate insulation pattern 270, a first conductive pattern 280, a first barrier pattern 290, a second conductive pattern 300 and a second gate mask 310 sequentially stacked.

A gate spacer structure 350 may be formed on sidewalls of the second gate structure 320. In example embodiments, the gate spacer structure 350 may include a first gate spacer 330 and a second gate spacer 340.

First impurity regions 102 may be formed at an upper portion of the second active pattern 105 adjacent to the second gate structure 320. The second gate structure 320 and the first impurity regions 102 may serve as a peripheral transistor.

A first etch stop layer 360 may be formed along surface profiles of the second gate structure 320, the gate spacer structure 350 and the second active pattern 105. The first etch stop layer 360 may include, e.g., silicon nitride.

The first insulating interlayer 370 may be on the first etch stop layer 360, and may fill a space between the second gate structures 320. The first capping layer 380 may be on the first insulating interlayer 370 and the first etch stop layer 360. The first insulating interlayer 370 may include, e.g., silicon oxide, and the first capping layer 380 may include, e.g., silicon nitride.

A stacked structure including the third conductive pattern 235, the second barrier pattern 245, the fourth conductive pattern 255 and the first mask 265 included in the bit line structure 395 may be the same as a stacked structure including the first conductive pattern 280, the first barrier pattern 290, the second conductive pattern 300 and the second gate mask 310 included in the second gate structure 320.

The first etch stop pattern 365 of the bit line structure 395 may be formed by a deposition process and may be substantially the same as a deposition process of the first etch stop layer 360 on the second region II of the substrate 100. Therefore, the first etch stop pattern 365 of the bit line structure 395 and the first etch stop layer 360 on the second region II of the substrate 100 may include substantially the same material. The first capping pattern 385 of the bit line structure 395 may be formed by a deposition process substantially the same as a deposition of the first capping layer 380 on the second region II of the substrate 100. Therefore, the first capping pattern 385 of the bit line structure 395 and the first capping layer 380 on the second region II of the substrate 100 may include substantially the same material.

A spacer structure may be formed on sidewalls of the bit line structure 395. The spacer structure may include a plurality of spacers stacked on the sidewalls of the bit line structure 395. In example embodiments, the spacer structure may include first to fourth spacers 400, 430, 450 and 490 sequentially stacked on the sidewalls of the bit line structure 395. Each of the first spacer 400, the third spacer 430, and the fourth spacer 490 may include, e.g., silicon nitride. The second spacer 430 may include, e.g., silicon oxide. For example, the second spacer 430 may be an air spacer including air. However, example embodiments are not limited thereto.

Fence insulation patterns may be on the first gate structures 160 positioned between the bit line structures 395, respectively.

A third opening 440 may be defined as a space between the bit line structures 395 and a space between the fence insulation patterns, and the third opening 440 may expose the first active pattern 103. A lower contact plug 475 and an upper contact plug structure 584 may be formed in the third opening 440. The lower contact plug 475 and the upper contact plug structure 584 may serve as a contact plug structure. The contact plug structure may contact the first active pattern 103 of the substrate 100.

The lower contact plug 475 may fill a lower portion of the third opening 440. The lower contact plug 475 may include, e.g., polysilicon doped with impurities. However, example embodiments are not limited thereto.

In some example embodiments, an upper surface of the lower contact plug 475 may be higher than an upper surface of the third conductive pattern 235 of the bit line structure 395, and may be lower than an upper surface of the first capping pattern 385.

In some example embodiments, a first metal silicide pattern 500 may be between the lower contact plug 475 and the upper contact plug structure 584. The first metal silicide pattern 500 may include, e.g., cobalt silicide, nickel silicide, titanium silicide, or the like. However, example embodiments are not limited thereto.

A fifth opening 590 may be disposed between the upper contact plug structures 584. A second upper insulation pattern 592 may be formed in the fifth opening 590. The second upper insulation pattern 592 may be disposed between upper portions of the upper contact plug structures 584. A bottom of the second upper insulation pattern 592 may be lower than an uppermost surface of the bit line structure 395, and the lower portion of the second upper insulation pattern 592 may contact the first capping pattern 385 of the bit line structure 395 and the spacer structure.

An upper portion of the bit line structure 395 and the spacer structure contacting the bottom of the fifth opening 590 may have a recessed portion by partially etching. In example embodiments, a lower surface of the fifth opening 590 may contact a portion of the second spacer 430.

The second upper insulation pattern 592 may include a material that blocks diffusion of an impurity gas such as chlorine. The second upper insulation pattern 592 may include, e.g., silicon nitride. The second upper insulation pattern 592 may not include the material of the hydrogen diffusing insulation pattern 570. The second upper insulation pattern 592 may not include, e.g., SiCN, SiO2, or SiBN. However, example embodiments are not limited thereto.

The first contact hole 510 may pass through the first capping layer 380, the first insulating interlayer 370 and the first etch stop layer 360 on the second region II of the substrate 100, and may expose the second active pattern 105. For example, the first contact hole 510 may expose the first impurity region 102 adjacent to the second gate structure 320.

The first conductive structure 556 may be on the first capping layer 380, and may fill the first contact hole 510. The first conductive structure 556 may include a third barrier pattern 550 and a first metal layer pattern 552. The first conductive structure 556 may include a first contact plug filling the first contact hole 510 and a first conductive line on the first capping layer 380. The upper surface of the first conductive structure 556 may be positioned higher than the second gate structure 320.

A second metal silicide pattern 512 may be between the bottom of the first contact plug and the second active pattern 105.

A fourth opening 560 may be formed between the first conductive structures 556. At least a portion of the upper portion of the first insulating interlayer 370 may be exposed by a bottom of the fourth opening 560.

A first upper insulation structure 574 including the hydrogen diffusing insulation pattern 570 and the first upper insulation pattern 572 may be formed in the fourth opening 560. The hydrogen diffusing insulation pattern 570 may be formed along a surface of the fourth opening 560, and the first upper insulation pattern 572 may be on the hydrogen diffusing insulation pattern 570 to fill the fourth opening 560. The hydrogen diffusing insulation pattern 570 may surround sidewalls and a bottom of the first upper insulation pattern 572. The hydrogen diffusing insulation pattern 570 may contact at least an upper portion of the first insulating interlayer 370. The first upper insulation pattern 572 may be disposed between upper portions of the first conductive structures 556, and may pass through the first capping layer 380.

The hydrogen diffusing insulation pattern 570 may include a material through which the hydrogen may easily diffuse. The hydrogen diffusing insulation pattern 570 may include the material having a hydrogen diffusivity higher than a hydrogen diffusivity of the silicon nitride. The hydrogen diffusing insulation pattern 570 may include silicon oxide or silicon nitride mixed (or doped) with the other material as impurities.

In some example embodiments, the hydrogen diffusing insulation pattern 570 may include, e.g., SiCN, SiO2, SiBN, or the like. However, example embodiments are not limited thereto. Since the silicon nitride is a material that hardly diffuses the hydrogen, the hydrogen diffusing insulation pattern 570 may not include silicon nitride. The first upper insulation pattern 572 may include the silicon nitride.

Upper surfaces of the upper contact plug structure 584, the second upper insulation pattern 592, the hydrogen diffusing insulation pattern 570, the first upper insulation structure 574, and the first conductive structure 556 may be substantially flat, and/or may be substantially coplanar with each other. A second etch stop layer 600 may be on the upper contact plug structure 584, the second upper insulation pattern 592, the hydrogen diffusing insulation pattern 570, the first upper insulation structure 574 and the first conductive structure 556.

The second etch stop layer 600 may include a material that has an etch selectivity with respect to the silicon oxide. The second etch stop layer 600 may include the material through which the hydrogen may easily diffuse. The second etch stop layer 600 may include a material having a hydrogen diffusivity higher than a hydrogen diffusivity of the silicon nitride. In example embodiments, the second etch stop layer 600 may include, e.g., SiCN or SiBN. However, example embodiments are not limited thereto. The second etch stop layer 600 may not include silicon nitride.

The second etch stop layer 600, the hydrogen diffusing insulation pattern 570 and the first insulating interlayer 370 may be connected to each other on the second region II of the substrate 100. The hydrogen may be diffused through a path of the second etch stop layer 600, the hydrogen diffusing insulation pattern 570 and the first insulating interlayer 370.

The cell capacitor 616 may pass through the second etch stop layer 600, and may contact the upper contact plug structure 584 on the first region I of the substrate 100. The cell capacitor 616 may include a lower electrode 610, a dielectric layer 612 and an upper electrode 614. A plate electrode 620 may be further included on the upper electrode 614.

The lower electrode 610 and the upper electrode 614 may include a metal. The lower electrode 610 and the upper electrode 614 may include, e.g., titanium nitride, polysilicon, tungsten, or the like. The dielectric layer 612 may include a metal oxide having a dielectric constant higher than a dielectric constant of the silicon nitride. The dielectric layer may include, e.g., aluminum oxide, hafnium oxide, or zirconium oxide. However, example embodiments are not limited thereto.

The second insulating interlayer 700 may cover the cell capacitor 616 and the second etch stop layer 600. Upper interconnections may be included in the second insulating interlayer 700. The low-k dielectric layers 710a, 710b, and 710c may be formed on the second insulating interlayer 700, and multilayer metal wirings may be formed in the low-k dielectric layers 710a, 710b, and 710c.

The hydrogen supplying oxide layer 720 may be on an uppermost low-k dielectric layer 710c, and an upper capping layer 722 may be on the hydrogen supplying oxide layer 720. The hydrogen supplying oxide layer 720 may include a high-density plasma oxide layer (HDP), a plasma enhanced CVD silane oxide layer, or the like. However, example embodiments are not limited thereto.

As described above, in the semiconductor device, the second upper insulation pattern 592 between contact structure electrically connected to the cell capacitor 616 on the first region of the substrate and the first upper insulation pattern 572 between first contact structures on the second region II of the substrate 100 may have different stacked structures. The second upper insulation pattern 592 may include the material for blocking of the diffusion of chlorine, so that chemical damage of the substrate 100 due to the diffusion of chlorine may be prevented or decreased. In addition, since the first upper insulation structure 574 includes the hydrogen diffusing insulation pattern 570, the path for the hydrogen diffusion may be generated between the second etch stop layer 600 and the first insulating interlayer 370. Therefore, the hydrogen may easily diffuse onto the surface of the substrate 100, and the trap sites at the interface between the first gate insulation pattern 130 and the substrate 100, and the interface between the second gate insulation pattern 270 and the substrate 100 may be removed by the hydrogen. Therefore, characteristics of the transistors formed on the substrate 100 may be improved.

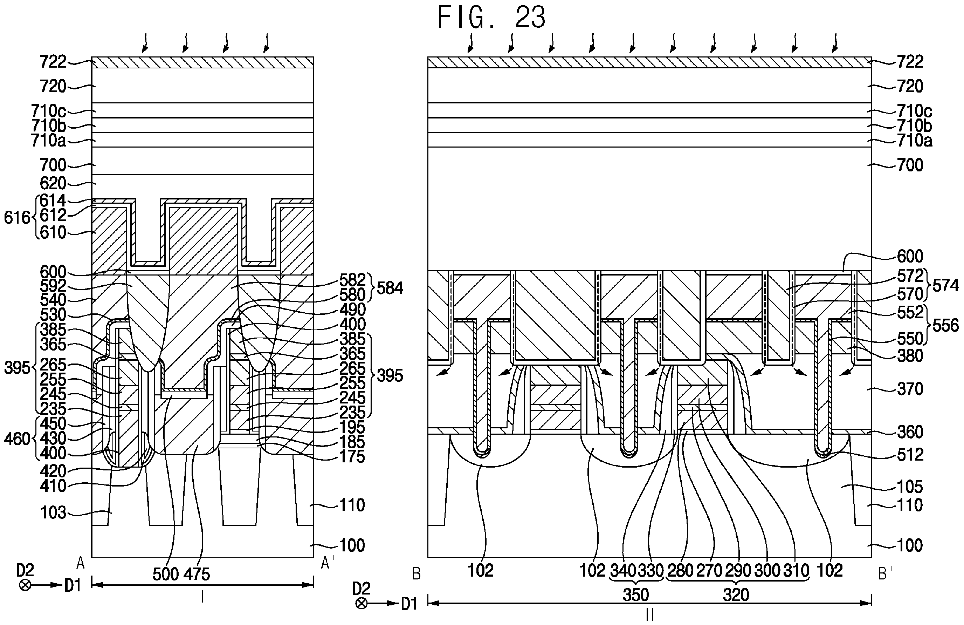

FIG. 23 is a cross-sectional view illustrating a semiconductor device according to various example embodiments.

The semiconductor device shown in FIG. 23 may be the same as the semiconductor device shown in FIG. 22, except for a first upper insulation structure and a second etch stop layer. Therefore, redundant descriptions may be omitted.

Referring to FIG. 23, the first upper insulation structure 574 may include a first upper insulation pattern 572 and a hydrogen diffusing insulation pattern 570. The first upper insulation structure 574 may pass through the second etch stop layer 600. That is, the second etch stop layer 600 may not cover the upper surface of the first upper insulation structure 574. In the second region II of the substrate 100, the second etch stop layer 600 may cover only the upper surface of the first conductive structure 556. The upper surface of the first upper insulation structure 574 and an upper surface of the second etch stop layer 600 may be substantially coplanar with each other.

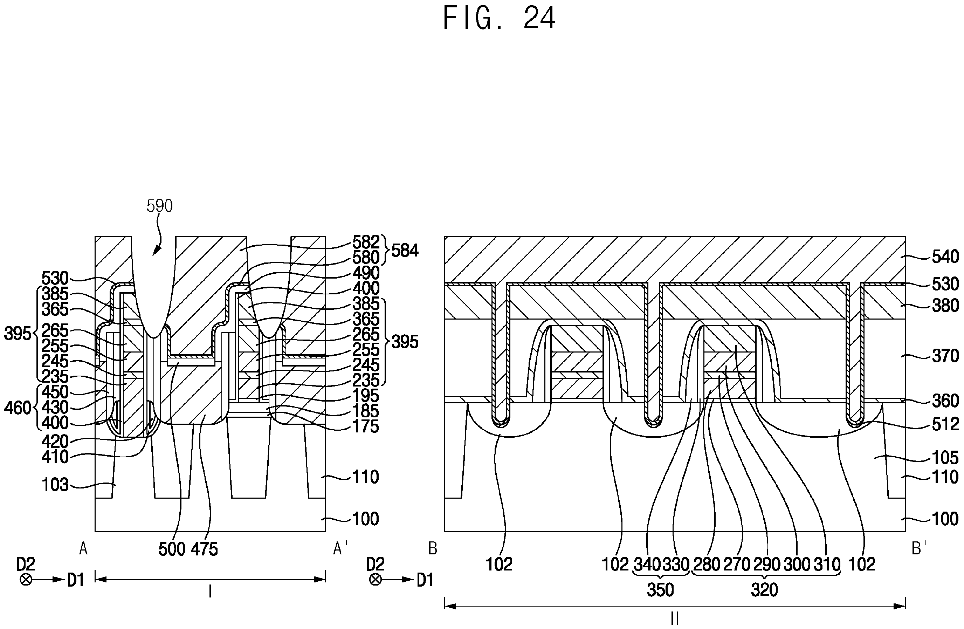

FIGS. 24 to 27 are cross-sectional views illustrating a method of manufacturing a semiconductor device according to various example embodiments.

Referring to FIG. 24, first, the structure shown in FIG. 15 may be formed by performing the processes described with reference to FIGS. 1 to 15.

The first metal layer 540 and the second barrier layer 530 on the first region I of the substrate 100 may be patterned to form the upper contact plug structures 584 and the fifth opening 590. The etching mask pattern used in the patterning process may cover all of the first metal layer 540 on the second region II of the substrate 100.

As the fifth opening 590 is formed, the first metal layer 540 and the second barrier layer 530 on the first region I of the substrate 100 may be transformed into the second metal pattern 582 and the fourth barrier pattern 580 covering the second metal pattern 582, respectively. The first metal layer 540 and the second barrier layer 530 may serve as an upper contact plug structure 584.

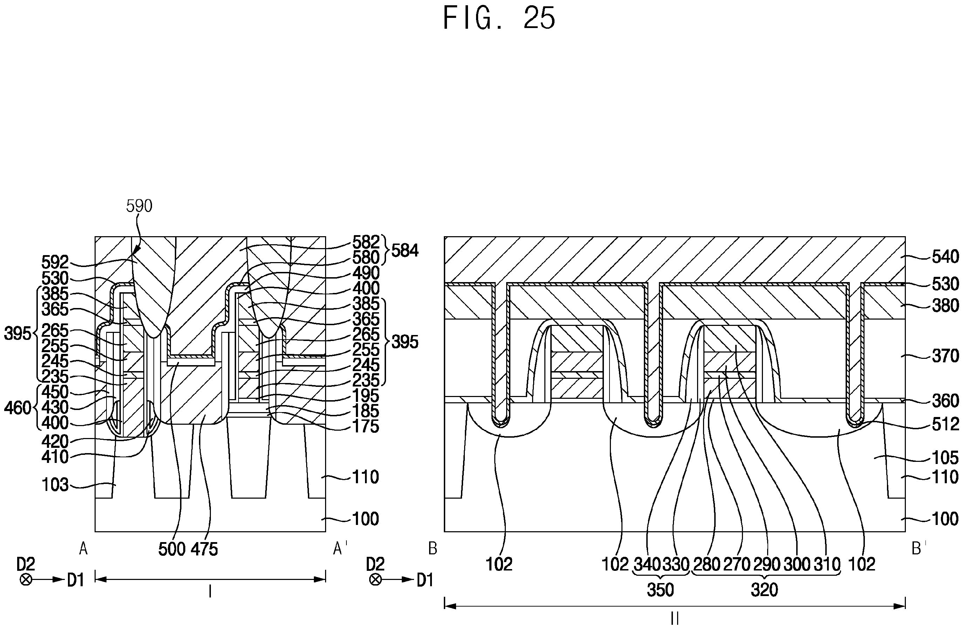

Referring to FIG. 25, a seventh insulation layer may be formed on the fifth opening 590, the upper contact plug structure 584 and the first metal layer to fill the fifth opening 590.

Thereafter, the seventh insulation layer may be planarized until the upper contact plug structure 584 and the first metal layer 540 are exposed to form the second upper insulation pattern 592 in the fifth opening 590.

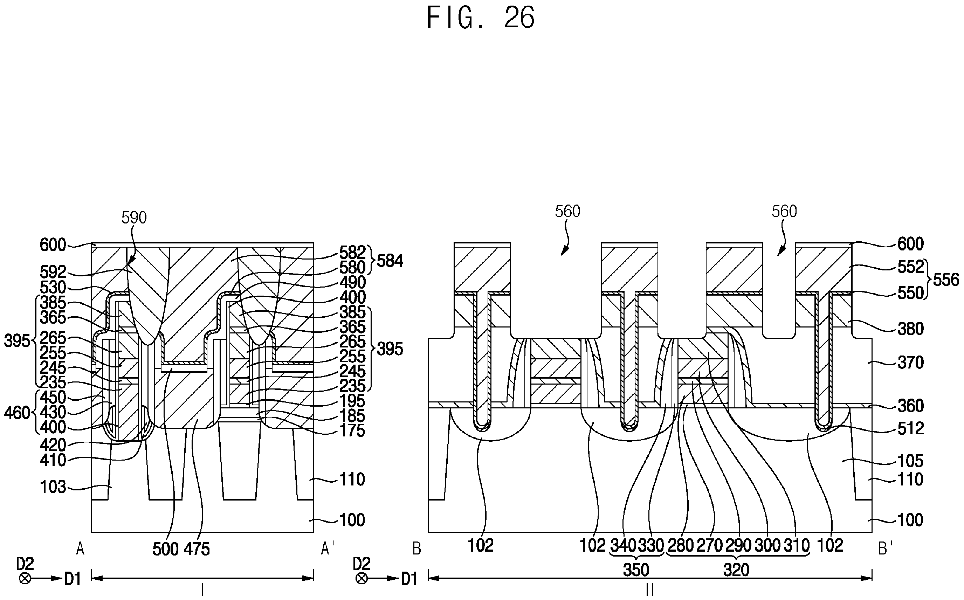

Referring to FIG. 26, a second etch stop layer 600 may be formed on the upper contact plug structure 584, the second upper insulation pattern 592, and the first metal layer 540.

An etching mask pattern may be formed on the second etch stop layer 600. The second etch stop layer 600, the first metal layer 540, the second barrier layer 530, and the first capping layer 380 may be patterned using the etching mask pattern to form the first conductive structures 556 and the fourth opening 560. The etching mask may entirely cover the second etch stop layer 600 on the first region I of the substrate 100.

The first conductive structures 556 may include a third barrier pattern 550 and a first metal layer pattern 552. After that, the etching mask pattern may be removed.

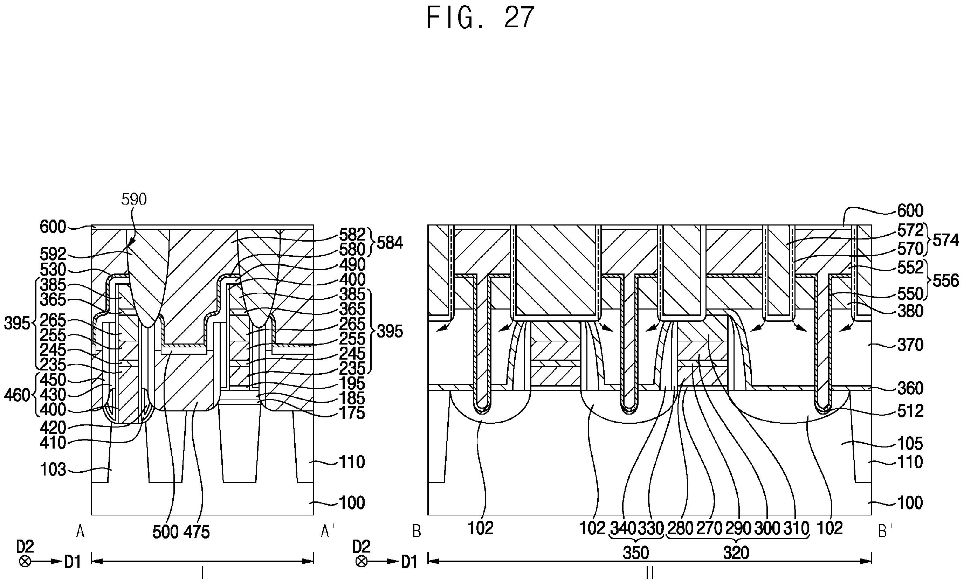

Referring to FIG. 27, a hydrogen diffusing insulation layer may be conformally formed on the surfaces of the fourth opening 560 and the second etch stop layer 600. A sixth insulation layer may be formed on the hydrogen diffusing insulation layer to fill the fourth opening 560. The sixth insulation layer may include silicon nitride.

Thereafter, the hydrogen diffusing insulation layer and the sixth insulation layer may be planarized until the second etch stop layer is exposed to form a hydrogen diffusing insulation pattern 570 and a first upper insulation pattern 572 in the fourth opening 560. The hydrogen diffusing insulation pattern 570 and the first upper insulation pattern 572 may serve as the first upper insulation structure 574. The hydrogen diffusing insulation pattern 570 may be formed along sidewalls and a bottom of the first upper insulation pattern 572. The hydrogen diffusing insulation pattern 570 may surround the sidewalls and the bottom of the first upper insulation pattern 572.

Thereafter, the cell capacitor 616 may be formed through the second etch stop layer 600, and may contact the upper contact plug structure 584 on the first region I of the substrate 100. The plate electrode 620 may be formed on the cell capacitor 616.

In addition, a second insulating interlayer 700 may be formed to cover the plate electrode 620 and the second etch stop layer 600, and an upper wiring may be formed on the second insulating interlayer 700. Low-k dielectric layers 710a, 710b and 710c may be formed on the second insulating interlayer, and multi-layered metal wirings (not shown) may be formed in the low-k dielectric layers 710a, 710b and 710c.

The processes for forming the cell capacitor 616, the plate electrode 620, the second insulating interlayer 700, the upper wiring, the low-k dielectric layers 710a, 710b, and 710c, and the metal wirings may be substantially the same as the processes described with reference to FIGS. 21 and 22.

By performing the above processes, the semiconductor device shown in FIG. 23 may be manufactured.

While the present inventive concepts have been shown and described with reference to some example embodiments thereof, it will be understood by those of ordinary skill in the art that various changes in form and details may be made thereto without departing from the scope of the present inventive concepts as set forth by the following claims.

## Claims

1. A semiconductor device, comprising:
a substrate (100) including a cell region (I) and a peripheral circuit region (II);
a first gate structure (160) in the cell region (I) of the substrate (100), the first gate structure (160) extending in a first direction (D1) parallel to an upper surface of the substrate (100);
bit line structures (395) on the cell region (I) of the substrate (100), the bit line structures (395) extending in a second direction (D2) perpendicular to the first direction (D1) and parallel to the upper surface of the substrate (100);
a second gate structure (320) on the peripheral circuit region (II) of the substrate (100);
contact plug structures (475, 500, 584) between the bit line structures (395), the contact plug structures contacting the substrate (100);
first conductive structures (556) on peripheral circuit region (II) of the substrate (100), the first conductive structures (556) being electrically connected to the peripheral circuit region (II) of the substrate (100);
a first upper insulation structure (574) between the first conductive structures (556), the first upper insulation structure (574) including a first upper insulation pattern (572) and a hydrogen diffusing insulation pattern (570) surrounding a bottom and sidewalls of the first upper insulation pattern (572); and
a second upper insulation pattern (592) between upper portions (584) of the contact plug structures (475, 500, 584).

2. The semiconductor device of claim 1, wherein the hydrogen diffusing insulation pattern (570) includes a material having a hydrogen diffusivity higher than a hydrogen diffusivity of silicon nitride.

3. The semiconductor device of claim 1 or 2, wherein the hydrogen diffusing insulation pattern (570) includes at least one of SiCN, SiBN, or SiO2.

4. The semiconductor device of any preceding claim, wherein the first and second upper insulation patterns (572, 592) include silicon nitride.

5. The semiconductor device of any preceding claim, further comprising:
an insulating interlayer (370) on the peripheral circuit region (II) of the substrate (100), the insulating interlayer (370) covering the second gate structure (320);
the insulating interlayer (370) including silicon oxide;
a first capping layer (380) on the peripheral circuit region (II) of the substrate (100), the first capping layer (380) covering the insulating interlayer (370); and
the first capping layer (380) including silicon nitride,
wherein at least a portion of the hydrogen diffusing insulation pattern (570) in the first upper insulation structure (574) directly contacts the insulating interlayer (370).

6. The semiconductor device of any preceding claim, further comprising:
an etch stop layer (600) on the first conductive structure (556), the first upper insulation structure (574), the contact plug structure (475, 500, 584), and the second upper insulation pattern (592); and
a cell capacitor (616) on the cell region (I) of the substrate (100), the cell capacitor (616) passing through the etch stop layer (600) and contacting the contact plug structure (475, 500, 584).

7. The semiconductor device of claim 6, wherein the etch stop layer (600) includes a material having an etch selectivity with respect to silicon oxide and having a hydrogen diffusivity higher than a hydrogen diffusivity of silicon nitride.

8. The semiconductor device of claim 6 or 7, wherein the etch stop layer (600) includes at least one of SiCN or SiBN.

9. The semiconductor device of any preceding claim, wherein the bit line structure (395) includes a conductive pattern (235, 255) and a capping pattern (385), and a spacer structure (400) is further on sidewalls of the bit line structure (395).

10. The semiconductor device of claim 9, wherein a bottom of the second upper insulation pattern (592) is lower than an uppermost surface of the bit line structure (395), and a lower portion of the second upper insulation pattern (592) contacts the capping pattern (385) and the spacer structure (400).

11. A semiconductor device of claim 1, comprising:
an insulating interlayer (370) covering sidewalls of the second gate structure (320) on the peripheral circuit region (II) of the substrate (100);
a first capping layer (380) covering the insulating interlayer (370) on the peripheral circuit region (II) of the substrate (100),
wherein the first conductive structures (556) are on the first capping layer (380), and a portion of the first conductive structures (556) passes through the first capping layer (380) and the insulating interlayer (370),
wherein the hydrogen diffusing insulation pattern (570) includes a material having a hydrogen diffusivity higher than a hydrogen diffusivity of silicon nitride, and
wherein at least a portion of the hydrogen diffusing insulation pattern (570) directly contacts the insulating interlayer (370).

12. The semiconductor device of claim 11, wherein the hydrogen diffusing insulation pattern (570) includes at least one of silicon oxide, or silicon nitride mixed with other materials as impurities.

13. The semiconductor device of claim 11 or 12, wherein the first and second upper insulation patterns (572, 592) include silicon nitride.

14. The semiconductor device of any one of claims 11 to 13, wherein the insulating interlayer (370) includes silicon oxide, and the first capping layer (380) includes silicon nitride.

15. The semiconductor device of any one of claims 11 to 14, further comprising:
an etch stop layer (600) on the first conductive structure (556), the first upper insulation structure (574), the contact plug structure (475, 500, 584), and the second upper insulation pattern (592), the etch stop layer (600) includes a material having a hydrogen diffusivity higher than a hydrogen diffusivity of silicon nitride; and
a cell capacitor (616) on the cell region (I) of the substrate (100), the cell capacitor (616) passing through the etch stop layer (600) and contacting the contact plug structure (475, 500, 584).
